# EUROPEAN PATENT SPECIFICATION

(11) **EP 4 231 338 B1**
(45) Date of publication and mention of the grant of the patent: **20.05.2026**
(21) Application number: 21946242.1
(22) Date of filing: 28.12.2021
(51) Int. Cl.: H01L 21/68, H01L 21/60, H01L 21/67, H01L 23/00

(54) **BONDING SYSTEM AND BONDING METHOD**
VERBINDUNGSSYSTEM UND VERBINDUNGSVERFAHREN
SYSTÈME DE COLLAGE ET PROCÉDÉ DE COLLAGE

(30) Priority: 24.12.2021 CN 202111595678
(43) Date of publication of application: 23.08.2023
(73) Proprietor: HUBEI 3D SEMICONDUCTOR INTEGRATED INNOVATION CENTER CO., LTD., Wuhan, Hubei 430000 (CN); Hubei Yangtze Memory Laboratories, Wuhan, Hubei 430000 (CN)
(72) Inventor: TIAN, Yingchao, Wuhan, Hubei 430000 (CN); LIU, Tianjian, Wuhan, Hubei 430000 (CN); CAO, Ruixia, Wuhan, Hubei 430000 (CN); CHENG, Qu, Wuhan, Hubei 430000 (CN)
(74) Representative: Gevers Patents
(86) International application number: PCT/CN2021/142109
(87) International publication number: WO 2023/115615

(56) References cited:
- CN-A- 1 893 012
- CN-A- 108 155 124
- CN-A- 109 585 328
- CN-A- 110 783 234
- CN-A- 112 018 002
- JP-A- 2008 244 255
- JP-A- 2013 235 907
- KR-A- 20210 033 573
- KR-B1- 102 134 069
- US-A1- 2007 134 904
- US-A1- 2020 075 381
- US-A1- 2020 083 193
- US-A1- 2020 219 850

## Description

### CROSS-REFERENCE TO RELATED APPLICATIONS

This application is based on and claims priority to Chinese Patent Application No. 202111595678.5 filed on December 24, 2021 and entitled "BONDING SYSTEM AND BONDING METHOD".

### TECHNICAL FIELD

Embodiments of the present disclosure relate to, but are not limited to the field of semiconductor manufacturing, and in particular to a bonding system and a bonding method.

### BACKGROUND

In the field of semiconductor manufacturing, three-dimensional (3D) integration of semiconductor devices may be implemented by using bonding technologies. Performance of chips may be improved by bonding two or more semiconductor structures with the same or different functions. Furthermore, metal interconnection between to-be-bonded objects may also be greatly shortened, reducing heating, power consumption and delay.

Bonding processes may be distinguished by bonding objects, and include wafer to wafer bonding, die to wafer bonding and die to die bonding.

Related arts can be found in US 2007/134904 A1. US 2007/134904 A1 provides a die bonding apparatus and a bonding method. The apparatus includes a bond head movable between a supply of semiconductor dice and a die bonding site, a pick-up tool attached to the bond head for holding a die to be bonded at the die bonding site and an optical assembly positioned for viewing an orientation of the die bonding site. The bond head is configured such that an orientation of the die being held by the pick-up tool between the optical assembly and the die bonding site is viewable by the optical assembly, whereby the orientation of the die may be aligned with the orientation of the die bonding site.

### SUMMARY

The present invention is defined in the claims.

In the embodiments of the present disclosure, the first deviation value between the current position of the first to-be-bonded die and the first target position may be determined by providing the first alignment assembly, and the second deviation value between the current position of the second to-be-bonded die on the wafer and the second target position may be determined by providing the second alignment assembly, and the wafer or the first to-be-bonded die is adjusted according to the first deviation value and the second deviation value, which may align the first to-be-bonded die with the second to-be-bonded die accurately, and is conducive to improving accuracy of die to wafer bonding, and may further reduce difficulty of die to wafer bonding.

### BRIEF DESCRIPTION OF THE DRAWINGS

In order to explain specific implementations of the present disclosure or technical solutions in the related art more clearly, the drawings required to be used in descriptions of the specific implementations or the related art will be briefly introduced below. It is apparent that the drawings as described below are some implementations of the present disclosure, and other drawings may also be obtained by those ordinary skilled in the art according to these drawings without paying any creative work.
FIG. 1 shows a schematic view of a wafer to wafer bonding process according to an exemplary embodiment.
FIG. 2 shows a schematic view of die to wafer bonding according to an exemplary embodiment.
FIG. 3A shows a first schematic view of a bonding system according to an embodiment of the present invention.
FIG. 3B shows a first schematic view of an optical path of a bonding system according to an embodiment of the present disclosure.
FIG. 4A shows a second schematic view of a bonding system according to an embodiment of the present invention.
FIG. 4B shows a second schematic view of an optical path of a bonding system according to an embodiment of the present disclosure.
FIG. 5 shows a third schematic view of a bonding system according to an illustrative embodiment not forming part of the invention.
FIG. 6 shows a fourth schematic view of a bonding system according to an embodiment of the present disclosure.
FIG. 7 shows a fifth schematic view of a bonding system according to an embodiment of the present disclosure.
FIG. 8 shows a first schematic flowchart of a bonding method according to an embodiment of the present disclosure.
FIG. 9 shows a first schematic process view of a bonding method according to an embodiment of the present invention.
FIG. 10 shows a second schematic process view of a bonding method according to an embodiment of the present invention.
FIG. 11 shows a third schematic process view of a bonding method according to an embodiment of the present disclosure.
FIG. 12 shows a fourth schematic process view of a bonding method according to an embodiment of the present disclosure.
FIG. 13 shows a schematic view of a die to wafer structure according to an embodiment of the present disclosure.

### Reference numerals:

101 - Upper wafer; 102, 102' - Lower wafer; 201 - Upper die; 202 - Lower wafer; 300 - Bonding system; 11 - First to-be-bonded die / First die; 21 - Second to-be-bonded die / Second die; 20 - Wafer; 301 - Bonding head; 301a - Top surface; 301b - Picking surface; 301c - Side surface; 302, 302' - First optical path; 302a, 302a' - First end of first optical path; 302b, 302b' - Second end of first optical path; 3021 - First reflector; 303 - Wafer stage; 304, 304', 304" - First alignment assembly; 3041, 3041', 3041" - Aligner; 305 - Second alignment assembly; 306, 306', 306" - Second optical path; 3061 - First sub-path; 3062 - Second sub-path; 3063 - Second reflector; 307 - Fixation unit; 308 - Mobile unit; 309 - Base; 310-1 - First bracket; 310-2 - Second bracket; 3041-1 - First aligner; 3041-2 - Second aligner; 302-1 - 1^{st} first optical path; 302-2 - 2^{nd} first optical path; 10 - Calibration die.

### DETAILED DESCRIPTION

The following embodiments are provided to understand the present disclosure better, and are not limited to best implementations, and do not limit contents and scope of protection of the present invention as defined by the appended claims. Any product which is obtained by anyone under an inspiration of the present disclosure or by combining the present disclosure with features of other related art and is the same as or similar to the present disclosure falls within the scope of protection of the present disclosure.

In descriptions of the present disclosure, it should be noted that terms indicating orientation or position relationships, such as "up", "down", "inside", "outside" or the like, are based on orientation or position relationships shown in the drawings, and are only intended to facilitate describing the present disclosure and simplify the descriptions, rather than indicating or implying that the referred device or element must have a specific orientation, and must be constructed and operated in a specific orientation, therefore they cannot be understood as limitation of the present disclosure. Furthermore, terms "first" and "second" are only for the purpose of descriptions, and cannot be understood as indicating or implying relative importance.

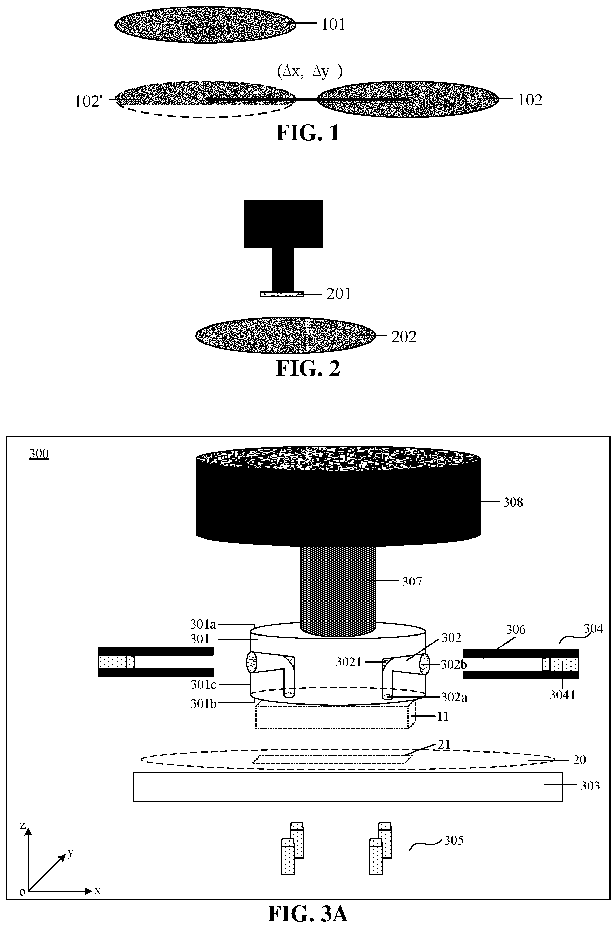

FIG. 1 shows a schematic view of a wafer to wafer bonding process according to an exemplary embodiment. With reference to FIG. 1, visual alignment is required before bonding an upper wafer 101 to a lower wafer 102. Specifically, a position of an alignment mark on a top surface of the lower wafer 102 is identified by using an upper lens located at a side of the upper wafer 101 away from the lower wafer 102, and is recorded as (x₂, y₂). A position of an alignment mark on a bottom surface of the upper wafer 101 is identified by using a lower lens located at a side of the lower wafer 102 away from the upper wafer 101, and is recorded as (x₁, y₁). A theoretical alignment deviation between the alignment mark on the bottom surface of the upper wafer 101 and the alignment mark on the top surface of the lower wafer 102 is (x₁ - x₂, y₁ - y₂).

It to be noted that when the position of the alignment mark on the bottom surface of the upper wafer 101 is identified by using the lower lens, the lower wafer 102 is required to move away (for example, move the lower wafer from a position 102' to a position 102) to avoid the lower wafer 102 blocking a visual field of the lower lens. Similarly, when the position of the alignment mark on the top surface of the lower wafer 102 is identified by using the upper lens, the upper wafer 101 is required to move away to avoid the upper wafer 101 blocking a visual field of the upper lens.

Movement errors may also occur during the lower wafer or the upper wafer moving away. Specifically, during wafer to wafer bonding, since the wafer has a relatively large size, only the upper lens / the lower lens is required to be used to identify the position of the alignment mark of the lower wafer 102 / the upper wafer 101 respectively, and a last wafer movement error (Δx, Δy) is recorded, the movement error may be monitored according to a displacement deviation of an electrostatic chuck adsorbing the wafer. Therefore, an actual alignment deviation between the alignment mark on the bottom surface of the upper wafer 101 and the alignment mark on the top surface of the lower wafer 102 is (x₁ - x₂ + Δx, y₁ - y₂ + Δy). Correction and alignment are performed according to the actual alignment deviation, and the bottom surface of the upper wafer 101 is bonded to the top surface of the lower wafer 102.

Die to wafer bonding is different from wafer to wafer bonding. Specifically, in a wafer to wafer bonding process, a top bonding object is the wafer, while in a die to wafer bonding process, a top bonding object is the die, and the die has a size much less than that of the wafer. Therefore, a bonding device for die to wafer bonding is greatly different from a bonding device for wafer to wafer bonding. For example, receiving incoming materials, visual alignment, downward bonding manner, or the like are different.

FIG. 2 shows a schematic view of die to wafer bonding according to an exemplary embodiment. With reference to FIG. 2, visual alignment is required before bonding an upper die 201 to a lower wafer 202. Specifically, an alignment mark of the upper die 201 is aligned with an alignment mark of a to-be-bonded die in the lower wafer 202.

Compared with conventional wafer to wafer bonding, die to wafer bonding has a higher accuracy requirement and is more difficult to bond. On one hand, since the lower wafer 202 and a carrier carrying the lower wafer 202 have large inertia, it is difficult for the lower wafer 202 to move with high frequency and high accuracy in a vertical direction, and die to wafer bonding has a low efficiency. On the other hand, during the upper die 201 moving to a position where it is aligned with the to-be-bonded die in the lower wafer 202, since the lower wafer 202 has a large blocking range for the lower lens, a displacement error generated by the upper die 201 moving to the position where it is aligned with the to-be-bonded die in the lower wafer 202, is difficult to be identified and recorded by the lower lens, and die to wafer bonding has a low accuracy.

In view of this, the embodiments of the present disclosure provide a bonding system and a bonding method.

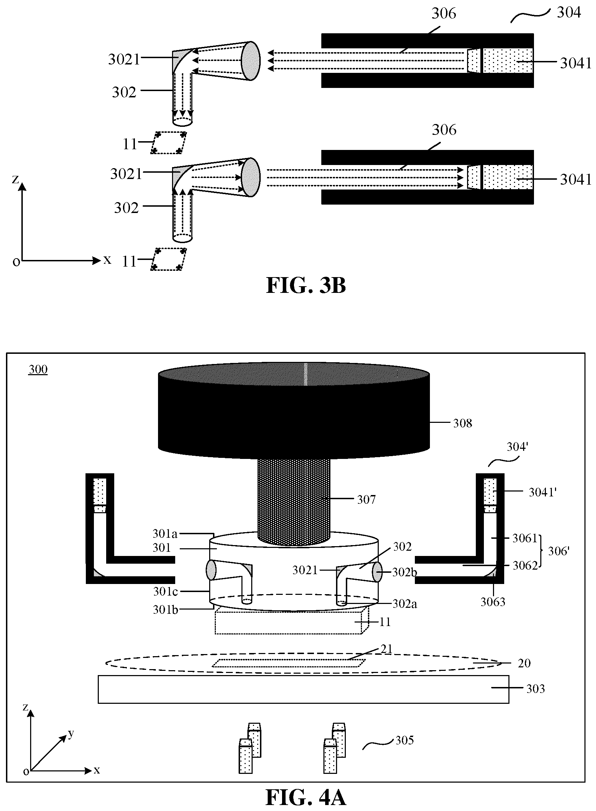

FIG. 3A and FIG. 3B show schematic views of a bonding system 300 according to an embodiment of the present invention, FIG. 3A represents a schematic structural view of the bonding system 300, FIG. 3B represents a schematic view of a part of the bonding system 300. With reference to FIG. 3A, the bonding system 300 includes a bonding assembly, a wafer stage 303, a first alignment assembly 304, and a second alignment assembly 305.

The bonding assembly includes a bonding head 301 configured to pick a first to-be-bonded die 11 and a first optical path 302 passing through the bonding head 301, here a first end 302a of the first optical path 302 is located at a picking surface 301b where the bonding head 301 picks the first to-be-bonded die 11.

The wafer stage 303 is configured to carry a wafer 20.

The first alignment assembly 304 is configured to transmit a detection optical signal to the first end 302a through a second end 302b of the first optical path 302, when the bonding assembly is located at a first position, here the picked first to-be-bonded die 11 covers the first end 302a and reflects the detection optical signal.

The first alignment assembly 304 is further configured to receive a reflection optical signal generated by the first to-be-bonded die reflecting the detection optical signal 11, and determine a first deviation value between a current position of the first to-be-bonded die 11 and a first target position according to the received reflection optical signal.

The second alignment assembly 305 is located at a side of the wafer stage 303 away from the bonding assembly, and is configured to determine a second deviation value between a current position of a second to-be-bonded die 21 on the wafer 20 and a second target position.

The wafer stage 303 is further configured to drive, according to the first deviation value and the second deviation value, the carried wafer 20 to move relative to the picking surface 301b, to align the second to-be-bonded die 21 with the first to-be-bonded die 11; or the bonding assembly is further configured to drive, according to the first deviation value and the second deviation value, the picking surface 301b where the first to-be-bonded die 11 is picked to move relative to the wafer stage 303, to align the first to-be-bonded die 11 with the second to-be-bonded die 21.

The bonding assembly is further configured to bond the first to-be-bonded die 11 to the second to-be-bonded die 21.

Exemplarily, with reference to FIG. 3A, after the bonding head 301 of the bonding assembly picks the first to-be-bonded die 11, the bonding assembly may move in a horizontal direction (e.g., x direction or y direction) and/or a vertical direction (e.g., z direction) and may be adjusted to the first position. Here, the first position represents a position where the second end 302b of the first optical path 302 may receive the detection optical signal transmitted by the first alignment assembly 304.

Exemplarily, with reference to FIG. 3A and FIG. 3B, the first alignment assembly 304 transmits the detection optical signal when the bonding assembly is located at the first position, the detection optical signal is transmitted to a positioning mark of the first to-be-bonded die 11 through the second end 302b and the first end 302a of the first optical path 302, and forms the reflection optical signal, the reflection optical signal is transmitted to the first alignment assembly 304 through the first end 302a and the second end 302b of the first optical path 302.

Exemplarily, after receiving the reflection optical signal, the first alignment assembly 304 may determine the first deviation value (Δx_{T}, Δy_{T}) between the current position (x₁, y₁) of the first to-be-bonded die 11 and the first target position (x₀, y₀) according to the reflection optical signal, here Δx_{T} = x₁ - x₀, Δy_{T} = y₁ - yo.

Exemplarily, with reference to FIG. 3A, the second deviation value (Δx_{B}, Δy_{B}) between the current position (x₂, y₂) of the second to-be-bonded die 21 on the wafer 20 and the second target position (x₀', y₀') may be determined by using the second alignment assembly 305, here Δx_{B} = x₂ - xo', Δy_{T} = y₂ - y₀'.

It to be noted that the first target position and the second target position have the same position in the horizontal direction, while have different positions in the vertical direction, that is, x₀ is the same as x₀', y₀ is the same as y₀', and the first target position and the second target position have different coordinates in the z direction. Different reference numerals are only intended to facilitate distinction between the first target position and the second target position, and are not intended to limit the present disclosure.

Here, the current position (x₁, y₁) of the first to-be-bonded die 11, the first target position (x₀, y₀), the current position (x₂, y₂) of the second to-be-bonded die 21 and the second target position (x₀', y₀') are determined based on the same coordinate system. For example, a coordinate system may be established by taking center of the wafer stage as an origin, x and y directions are perpendicular to each other and parallel to a plane where the wafer stage is located, and z direction is perpendicular to the plane where the wafer stage is located.

Before die to wafer bonding, a standard die may be used to calibrate positions of the first alignment assembly, the second alignment assembly and the bonding assembly, to ensure that the first alignment assembly may be aligned with the second end of the first optical path, and that the second alignment assembly may be aligned with a positioning mark on a surface of the standard die facing the wafer stage, thus determining the first target position and the second target position. Here, the first target position represents a position of the standard die after calibration, and coordinate in the horizontal direction is marked as (x₀, y₀); a position with a preset distance from the first target position in the vertical direction is marked as the second target position, coordinate of the second target position in the horizontal direction is marked as (x₀', y₀'), here the preset distance is greater than 0. It may be understood that although the first target position and the second target position have the same position in the horizontal direction (x and y directions), they are not the same position in a 3D space, and the first target position and the second target position have different positions in the vertical direction (z direction).

It may be understood that when the first to-be-bonded die is located at the first target position, and the second to-be-bonded die is located at the second target position, it may be considered that the first to-be-bonded die is aligned with the second to-be-bonded die. That is, a projection of the first to-be-bonded die on the wafer stage overlaps with the second to-be-bonded die in the vertical direction.

It should be emphasized that the current position of the first to-be-bonded die 11 represents an actual position of the first to-be-bonded die 11 when the bonding assembly is adjusted to the first position, and may have a deviation with respect to the first target position. The current position of the second to-be-bonded die 21 represents an actual position of the second to-be-bonded die 21 when the wafer 20 is placed on the wafer stage and a die required to be bonded on the wafer is determined to be the second to-be-bonded die, and may have a deviation with respect to the second target position.

When the current position of the first to-be-bonded die 11 is the first target position and the current position of the second to-be-bonded die 21 is the second target position, each of the first deviation value and the second deviation value is 0. Accurate alignment and bonding between the first to-be-bonded die and the second to-be-bonded die may be implemented by the wafer vertically moving upward or the first to-be-bonded die vertically moving downward.

Exemplarily, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The bonding assembly may be kept fixed (that is, the first to-be-bonded die 11 is kept fixed), and the wafer stage 303 drives the wafer 20 to move by (Δx_{T} - Δx_{B}, Δy_{T} - Δy_{B}) horizontally according to the displacement deviation, so that the second to-be-bonded die 21 is aligned with the first to-be-bonded die 11, that is, positions of the first to-be-bonded die 11 and the second to-be-bonded die 21 in the horizontal direction are the same.

Here, a direction in which the wafer stage 303 drives the wafer 20 to move may be determined according to a positive or negative value of Δx_{T} - Δx_{B}. For example, when Δx_{T} - Δx_{B} is a negative value, the wafer stage 303 drives the wafer 20 to move in a negative direction of x-axis, and a movement distance is an absolute value of (Δx_{T} - Δx_{B}). When Δx_{T} - Δx_{B} is a positive value, the wafer stage 303 drives the wafer 20 to move in a positive direction of x-axis, and a movement distance is (Δx_{T} - Δx_{B}).

Similarly, a direction in which the wafer stage 303 drives the wafer 20 to move may be determined according to a positive or negative value of Δy_{T} - Δy_{B}. For example, when Δy_{T} - Δy_{B} is a negative value, the wafer stage 303 drives the wafer 20 to move in a negative direction of y-axis, and a movement distance is an absolute value of (Δy_{T} - Δy_{B}). When Δy_{T} - Δy_{B} is a positive value, the wafer stage 303 drives the wafer 20 to move in a positive direction of y-axis, and a movement distance is (Δy_{T} - Δy_{B}).

Exemplarily, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The wafer stage 303 may be kept fixed (that is, the second to-be-bonded die 21 is kept fixed), and the bonding assembly moves by (Δx_{T} - Δx_{B}, Δy_{T} - Δy_{B}) horizontally according to the displacement deviation, so that the first to-be-bonded die 11 is aligned with the second to-be-bonded die 21.

Here, a direction in which the bonding assembly moves may be determined according to a positive or negative value of Δx_{T} - Δx_{B}. For example, when Δx_{T} - Δx_{B} is a negative value, the bonding assembly moves in a positive direction of x-axis, and a movement distance is an absolute value of (Δx_{T} - Δx_{B}). When Δx_{T} - Δx_{B} is a positive value, the bonding assembly moves in a negative direction of x-axis, and a movement distance is (Δx_{T} - Δx_{B}).

Similarly, a direction in which the bonding assembly moves may be determined according to a positive or negative value of Δy_{T} - Δy_{B}. For example, when Δy_{T} - Δy_{B} is a negative value, the bonding assembly moves in a positive direction of y-axis, and a movement distance is an absolute value of (Δy_{T} - Δy_{B}). When Δy_{T} - Δy_{B} is a positive value, the bonding assembly moves in a negative direction of y-axis, and a movement distance is (Δy_{T} - Δy_{B}).

In this example, after determining the first deviation value and the second deviation value, the first to-be-bonded die may be aligned with the second to-be-bonded die by driving the picking surface where the first to-be-bonded die is picked to move relative to the wafer stage, or by driving the carried wafer to move relative to the picking surface. Preferably, after determining the first deviation value and the second deviation value, the carried wafer is driven to move relative to the picking surface, to align the second to-be-bonded die with the first to-be-bonded die.

It to be noted that the die and the bonding head picking the die have relatively small sizes. When the bonding assembly is made to move relative to the wafer, the small-sized bonding head is more likely to fluctuate during movement of the bonding assembly, and may incline relative to the horizontal plane, leading to inclination of the die picked by the bonding head, affecting alignment and reducing bonding accuracy.

Compared with a manner of alignment by moving the bonding assembly relative to the wafer, when the wafer is driven to move relative to the picking surface, since the wafer has a size greater than that of the die, there is a small probability of a bonding surface of the wafer fluctuating in the horizontal plane during movement of the wafer, that is, the second to-be-bonded die bonded with the first to-be-bonded die is more horizontal, which is conducive to further improving accuracy of die to wafer bonding.

The bonding head 301 may adsorb the first to-be-bonded die 11 by vacuum adsorption or electrostatic adsorption. The first to-be-bonded die 11 may include a bonding surface and a non-bonding surface arranged opposite to each other. During die to wafer bonding, the picking surface picks the first to-be-bonded die 11 by adsorbing the non-bonding surface of the first to-be-bonded die 11.

The first to-be-bonded die 11 includes semiconductor chips, such as memory chips, communication chips, artificial intelligence (AI) chips, light emitting diode (LED) chips, sensor chips, display chips, or the like. With reference to FIG. 3A, the first to-be-bonded die 11 includes a front side and a back side arranged opposite to each other in the z direction. When the front side of the first to-be-bonded die 11 is provided with functional structures, the front side of the first to-be-bonded die 11 is the bonding surface, and the back side of the first to-be-bonded die 11 is the non-bonding surface.

It should be emphasized that the first to-be-bonded die 11, the wafer 20 and the second to-be-bonded die 21 are not included in the bonding system 300, and the first to-be-bonded die 11, the wafer 20 and the second to-be-bonded die 21 (shown in dash lines) are merely illustrative in FIG. 3A, to facilitate understanding position relationships among the to-be-bonded die, the bonding head and the wafer during die to wafer bonding.

The first optical path 302 includes the first end 302a and the second end 302b. The first end 302a is configured to output the detection optical signal and receive the reflection optical signal, and the second end 302b is configured to receive the detection optical signal and output the reflection optical signal. The first optical path 302 allows the detection optical signal and reflection optical signal to pass through, and may be a transparent window arranged in the bonding head 301, or an optical transmission medium arranged in the bonding head 301, such as an optical fiber or the like.

The first alignment assembly and the second alignment assembly may transmit the detection optical signal, may also receive the reflection optical signal, and may also convert the received reflection optical signal into a visual image. For example, the first alignment assembly may acquire a first image of a positioning mark on the first to-be-bonded die, and determine the first deviation value according to the first image. The second alignment assembly may acquire a second image of a positioning mark on the second to-be-bonded die, and determine the second deviation value according to the second image. The first alignment assembly and the second alignment assembly may transmit and receive infrared light signals (e.g., far infrared light signals).

The wafer stage 303 may include a chuck (not shown in the figure), such as an electrostatic chuck (ESC chuck), to adsorb the wafer 20.

In some embodiments, the wafer stage may move with respect to the picking surface, to drive the wafer to move with respect to the picking surface.

In some other embodiments, a mesa of the wafer stage configured to carry the wafer is not movable itself, however, the wafer stage includes a lift pin which may move relative to the picking surface. The wafer may be driven to move relative to the picking surface by driving the lift pin to move relative to the picking surface, to implement position adjustment of the wafer. The lift pin may be provided with a vacuum hole to absorb the wafer through vacuum. The lift pin may move in a plane parallel to the wafer, to drive the wafer to move, so as to adjust the position of the wafer.

Specifically, the wafer stage including the ESC chuck is taken as an example, the ESC chuck includes a fixed substrate and a lift pin, the lift pin passes through the fixed substrate in an axial direction of the ESC chuck and may move in a direction perpendicular to the fixed substrate and a direction parallel to the fixed substrate. When the ESC chuck carries a wafer, the lift pin may contact the wafer. When the lift pin moves towards the picking surface in the direction perpendicular to the fixed substrate, the carried wafer is jacked up by the lift pin and thus separated from the fixed substrate, and the carried wafer moves with the lift pin.

The wafer 20 includes multiple second to-be-bonded dies 21, each of the second to-be-bonded dies 21 includes a substrate and functional structures (such as a storage array or a functional circuit) on the substrate, and a cutting channel is arranged between two adjacent second to-be-bonded dies.

In the embodiments of the present disclosure, the first deviation value between the current position of the first to-be-bonded die and the first target position may be determined by providing the first alignment assembly, the second deviation value between the current position of the second to-be-bonded die on the wafer and the second target position may be determined by providing the second alignment assembly, and position of the wafer or the first to-be-bonded die is adjusted according to the first deviation value and the second deviation value, which may align the first to-be-bonded die with the second to-be-bonded die accurately, and is conducive to improving accuracy of die to wafer bonding.

In some embodiments, with reference to FIG. 3A and FIG. 3B, the bonding head 301 includes a side surface 301c perpendicular to the picking surface 301b, here the second end 302b of the first optical path 302 is arranged in the side surface 301c.

The first optical path 302 includes a first reflector 3021 configured to reflect an optical signal transmitted between the first end 302a of the first optical path 302 and the second end 302b of the first optical path 302.

The first alignment assembly 304 includes a second optical path 306 and an aligner 3041, here the aligner 3041 is configured to transmit a detection optical signal, receive a reflection optical signal, and determine a first deviation value.

Here, when the bonding assembly is located at the first position, the aligner 3041 is located at an end of the second optical path 306 away from the side surface 301c, and another end of the second optical path 306 close to the side surface 301c is aligned with the second end 302b of the first optical path 302.

Exemplarily, with reference to FIG. 3B, when the bonding assembly is located at the first position, the aligner 3041 transmits a detection optical signal which is transmitted to a positioning mark (shown by "+" in FIG. 3B) of the first to-be-bonded die 11 through the second optical path 306 and the first optical path 302 and forms a reflection optical signal, the reflection optical signal is transmitted to the aligner 3041 through the first optical path 302 and the second optical path 306.

Exemplarily, with reference to FIG. 3B, the first reflector 3021 is located between the first end 302a of the first optical path 302 and the second end 302b of the first optical path 302, and is configured to reflect the detection optical signal received by the second end 302b of the first optical path 302 to the first end 302a of the first optical path 302, so as to be transmitted to the positioning mark of the first to-be-bonded die 11, and is further configured to reflect a reflection optical signal received by the first end 302a of the first optical path 302 to the second end 302b of the first optical path 302, so as to be transmitted to the aligner 3041.

The aligner 3041 includes a device integrated with an optical transmitter and an optical detector. The optical transmitter is configured to transmit the detection optical signal, and the optical detector is configured to receive the reflection optical signal. Furthermore, the aligner 3041 may further include an image sensor connected to the optical detector and configured to convert the received reflection optical signal into a visual image, the first deviation value may be determined according to the image.

In the embodiments of the present disclosure, the second optical path and the aligner are arranged, the second optical path is aligned with the first optical path and is located between the aligner and the first optical path, which is conducive to transmission of the detection optical signal or reflection optical signal between the aligner and the first to-be-bonded die, may locate the current position of the first to-be-bonded die accurately, and is conducive to improving accuracy of the first deviation value.

Furthermore, the first alignment assembly and the bonding assembly are arranged separately, that is, the first alignment assembly is arranged outside the bonding assembly, which does not increase weight of the bonding assembly additionally and allows inertia of the bonding assembly to be small. Furthermore, since the first alignment assembly is arranged outside the bonding assembly, the first alignment assembly does not affect movement of the bonding assembly, which may ensure that the bonding assembly moves with high frequency and high accuracy in the vertical direction, improving bonding accuracy while improving bonding efficiency.

In some embodiments, with reference to FIG. 3A and FIG. 3B, when the bonding assembly is located at the first position, the second optical path 306 is parallel to the picking surface 301b. It may be understood that in the embodiments of the present disclosure, the second optical path may be arranged along the horizontal direction, and the detection optical signal and the reflection optical signal may be transmitted in the second optical path along the horizontal direction.

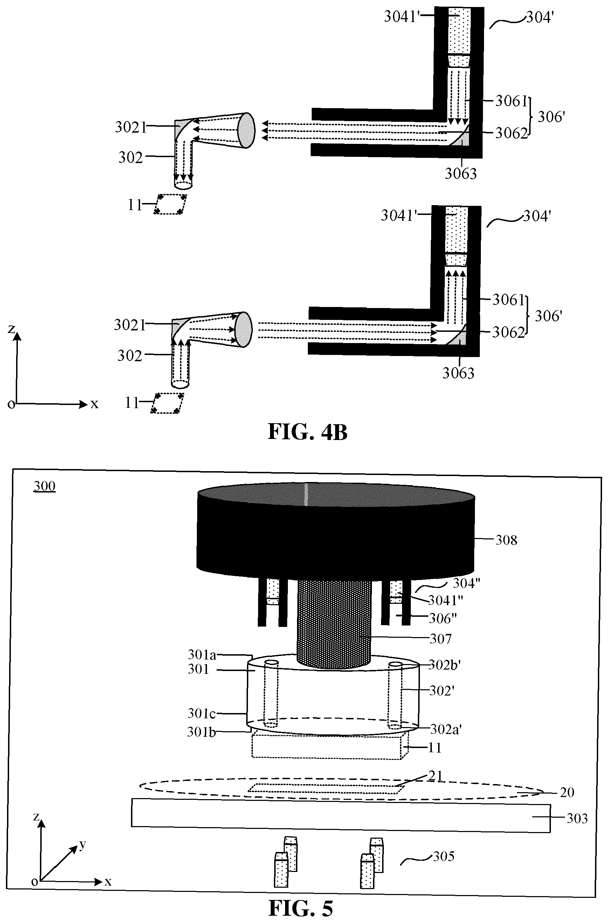

In some embodiments of the present invention, with reference to FIG. 4A and FIG. 4B, the second optical path 306' includes a first sub-path 3061, a second sub-path 3062, and a second reflector 3063. The first sub-path 3061 is perpendicular to the second sub-path 3062, the second reflector 3063 is located at intersection of the first sub-path 3061 and the second sub-path 3062 and is configured to reflect an optical signal transmitted between the first sub-path 3061 and the second sub-path 3062.

An aligner 3041' is located at an end of the first sub-path 3061 away from the second sub-path 3062.

Here, when the bonding assembly is located at the first position, the first sub-path 3061 is perpendicular to the picking surface 301b, the second sub-path 3062 is parallel to the picking surface 301b, and an end of the second sub-path 3062 close to the side surface 301c is aligned with the second end 302b of the first optical path 302.

Exemplarily, with reference to FIG. 4B, when the bonding assembly is located at the first position, the aligner 3041' transmits a detection optical signal which is transmitted to a positioning mark (shown by "+" in FIG. 4B) of the first to-be-bonded die 11 through the first sub-path 3061, the second sub-path 3062 and the first optical path 302 and forms a reflection optical signal, the reflection optical signal is transmitted to the aligner 3041' through the first optical path 302, the second sub-path 3062 and the first sub-path 3061.

Exemplarily, with reference to FIG. 4B, the second reflector 3063 is located between the first sub-path 3061 and the second sub-path 3062, and is configured to reflect the detection optical signal received by the first sub-path 3061 to the second sub-path 3062, so as to be transmitted to the first optical path 302, and is further configured to reflect a reflection optical signal received by the second sub-path 3062 to the first sub-path 3061, so as to be transmitted to the aligner 3041'.

Here, the aligner 3041' is the same as the aligner 3041 in the above embodiments, and is not repeated here in the present disclosure.

It may be understood that in the embodiments of the present disclosure, the second optical path may be configured as "L" shape, and include the first sub-path in the vertical direction and the second sub-path in the horizontal direction. When the second end of the first optical path is located on the side surface of the bonding head, the second sub-path is aligned with the second end of the first optical path to ensure transmission of the detection optical signal and reflection optical signal in the first optical path and the second optical path, and to locate the current position of the first to-be-bonded die accurately.

Furthermore, diversity of manners of configuring optical paths in the first alignment assembly is increased by configuring the second optical path as "L" shape. In a practical application, optical paths in the first alignment assembly may be configured reasonably by those skilled in the art according to actual requirements of the bonding process, which are not limited here by the present disclosure.

Preferably, the second optical path is arranged in the horizontal direction (as shown in FIG. 3A and FIG. 3B). Compared with the second optical path configured as "L" type (as shown in FIG. 4A and FIG. 4B), the second optical path is arranged in the horizontal direction, which may simplify design of the optical path, reduce transmission loss of the detection optical signal or reflection optical signal in the second optical path, improve accuracy of locating the first to-be-bonded die, and thus improve accuracy of the first deviation value.

In some illustrative embodiments not forming part of the invention, with reference to FIG. 5, the bonding head 301 further includes a top surface 301a parallel to the picking surface 301b, the top surface 301a includes a first area and a second area.

The bonding assembly further includes a fixation unit 307 and a mobile unit 308. The fixation unit 307 fixedly connects the first area to the mobile unit 308. The mobile unit 308 is configured to move the bonding head 301 relative to the wafer stage 303.

A first optical path 302' passes through the bonding head 301 in a direction perpendicular to the picking surface 301b, here a second end 302b' of the first optical path 302' is located in the second area.

A first alignment assembly 304" with a projection in the horizontal direction located in the second area, includes a second optical path 306" and an aligner 3041", here the aligner 3041" is configured to transmit a detection optical signal, receive a reflection optical signal, and determine a first deviation value.

Here, the second optical path 306" is perpendicular to the picking surface 301b and is aligned with the first optical path 302'. The aligner 3041" is located at an end of the second optical path 306" away from the bonding head 301.

Exemplarily, with reference to FIG. 5, the bonding head 301 includes a picking surface 301b and a top surface 301a arranged opposite to each other in the z direction. The fixation unit 307 is located between the bonding head 301 and the mobile unit 308. An end of the fixation unit 307 is fixedly connected to the top surface 301a of the bonding head 301, and another end of the fixation unit 307 is fixedly connected to the mobile unit 308.

Here, the first area represents an area where the top surface 301a of the bonding head 301 contacts the fixation unit 307, and the second area represents an area where the top surface 301a of the bonding head 301 does not contact the fixation unit 307. It may be understood that a projection of the fixation unit 307 in the horizontal direction is located in the first area.

Exemplarily, with reference to FIG. 5, the first optical path 302' passes through the bonding head 301, and includes a first end 302a' and a second end 302b'. It may be understood that a horizontal plane where the first end 302a' is located is flush with a horizontal plane where the picking surface 301b is located, and a horizontal plane where the second end 302b' is located is flush with a horizontal plane where the top surface 301a is located, and is located in the second area.

Exemplarily, with reference to FIG. 5, the first alignment assembly 304" is located above the first optical path 302', and the second optical path 306" is arranged parallel to the z-axis direction and is aligned with the first optical path 302'. In this example, the first alignment assembly 304" may be fixedly connected to the mobile unit 308.

In some embodiments, the first alignment assembly 304" may be arranged on the top surface 301a of the bonding head 301, as long as it ensures that the second optical path is aligned with the first optical path.

In some embodiments, the first alignment assembly 304" may be fixed through an external bracket, without being fixedly connected to the mobile unit 308, as long as it ensures that the second optical path is aligned with the first optical path. At this time, the fixation unit 307 configured to connect the mobile unit 308 to the bonding head 301 may be a retractable device to avoid the first alignment assembly 304" and the external bracket from blocking up and down movement of the bonding assembly.

It may be understood that a manner of fixing the first alignment assembly 304" through the external bracket does not increase weight of the bonding assembly additionally and allows inertia of the bonding assembly to be small, which may ensure that the bonding assembly moves with high frequency and high accuracy in the vertical direction, improving bonding accuracy while improving bonding efficiency.

Compared with the second end of the first optical path arranged on the side surface of the bonding head, it is configured in the embodiments of the present disclosure that the first optical path passes through the bonding head, the second end of the first optical path is located on the top surface of the bonding head. In this way, the detection optical signal or reflection optical signal may be transmitted in the first optical path along the vertical direction, without arranging the first reflector in the first optical path, which simplifies structure of the bonding assembly and is conducive to reducing difficulty of manufacturing the bonding assembly while reducing cost of manufacturing the bonding assembly.

Furthermore, since it is not required to add the first reflector in the first optical path additionally, loss caused by reflection of the detection optical signal or reflection optical signal at the position of the first reflector is reduced, which is conducive to locating the current position of the first to-be-bonded die accurately, and thus improving accuracy of the first deviation value.

In some embodiments, the bonding assembly includes two first optical paths, in which first ends of different first optical paths are arranged in different positions, and second ends of different first optical paths are arranged in different positions on the picking surface.

The first alignment assembly includes one aligner, here the aligner is aligned with a second end of one of the first optical paths, when the bonding assembly is located at the first position.

The bonding assembly further includes a driving unit configured to drive the two first optical paths to move relative to the aligner, so that the aligner is aligned with a second end of the other of the first optical paths.

Exemplarily, when the to-be-bonded die 11 includes two sets of positioning marks arranged in parallel along the x direction, each set of positioning marks includes a positioning mark, or at least two positioning marks arranged in parallel along the y direction. With reference to FIG. 3A, the bonding assembly may include two first optical paths 302 arranged in parallel along the x direction. When the bonding assembly is located at the first position, first ends 302a of the two first optical paths 302 expose two sets of positioning marks in the first to-be-bonded die 11 respectively.

Exemplarily, with reference to FIG. 3A and FIG. 3B, the first alignment assembly may include one aligner 3041 located at a side of the bonding head 301. When the bonding assembly is located at the first position, the aligner 3041 is aligned with a 1^{st} first optical path 302 to locate, through the 1^{st} first optical path 302, a position of a first set of positioning marks exposed by the 1^{st} first optical path 302.

Exemplarily, the driving unit may be connected with the mobile unit 308 to drive the mobile unit 308 to rotate clockwise or counter-clockwise relative to the aligner 3041. When the mobile unit 308 rotates, the fixation unit 307, the bonding head 301 and the first to-be-bonded die 11 rotate synchronously. In this way, a 2^{nd} first optical path 302 may be rotated to a position aligned with the aligner 3041, so that the aligner 3041 is aligned with the 2^{nd} first optical path 302 to locate, through the 2^{nd} first optical path 302, a position of a second set of positioning marks exposed by the 2^{nd} first optical path 302.

For example, the two first optical paths 302 are arranged in parallel along the x direction, and second ends 302b of the two first optical paths 302 are located in the same horizontal plane. After the aligner 3041 is aligned with the 1^{st} first optical path 302, the driving unit may drive the mobile unit 308 to clockwise or counter-clockwise rotate by 180° relative to the aligner 3041, so that the 2^{nd} first optical path 302 is aligned with the aligner 3041. At this time, the 1^{st} first optical path 302 rotates to an original position of the 2^{nd} first optical path 302.

It should be emphasized that during rotation of the mobile unit, the first to-be-bonded die 11 also rotates synchronously, therefore a current position of the first set of positioning marks may change after rotation. It should be understood that a coordinate system established to locate the first target position and the current position of the first set of positioning marks may also change after rotation.

For example, based on a coordinate system established before rotation, the current position of the first set of positioning marks is located as (x₃, y₃), and based on a coordinate system established after clockwise or counter-clockwise rotating by 180°, the current position of the first set of positioning marks is located as (-x₃, -y₃), and the first target position is located as (-x₀, -yo).

In a practical application, the bonding head may have a cylindrical shape, and the picking surface may have a circular shape. The position of the first set of positioning marks after rotation and the first target position after rotation may be determined according to angle and direction of rotation of the mobile unit 308 and a radius of the picking surface.

Exemplarily, based on the coordinate system established after clockwise or counter-clockwise rotating by 180°, the current position of the first set of positioning marks is marked as (-x₃, -y₃), and a current position of the second set of positioning marks is marked as (x₄, y₄). The current position (x₁', y₁') of the first to-be-bonded die 11 is determined according to the current position of the first set of positioning marks and the current position of the second set of positioning marks, here x₁' = (x₄ - x₃) / 2, y₁' = (y₄ - y₃) / 2. The first deviation value is marked as (Δx₁', Δy_{T}'), here Δx_{T}' = x₁' - (-xo), Δy_{T}' = y₁' - (-yo).

It may be understood that an angle of the mobile unit rotating relative to the aligner may be determined based on positions where the 1^{st} first optical path and the 2^{nd} first optical path are arranged. Here, the two first optical paths arranged in parallel along the x direction are merely illustrative, to convey the present disclosure to those skilled in the art. However, the present disclosure is not limited thereto. In other examples, the two first optical paths may also be arranged in other manners, for example, according to a manner of arranging multiple sets of positioning marks in the first to-be-bonded die.

In the embodiments of the present disclosure, one aligner may be provided, to implement alignment of one aligner with two first optical paths respectively, and then positioning marks on the first to-be-bonded die is located through the first optical path aligned with the aligner.

In some embodiments, the bonding assembly includes two first optical paths, in which first ends of different first optical paths are arranged in different positions, and second ends of different first optical paths are arranged in different positions on the picking surface.

The first alignment assembly includes two aligners and two second optical paths, in which different aligners are located at ends of different second optical paths away from the bonding head.

Here, different second optical paths are aligned with different first optical paths, when the bonding assembly is located at the first position.

Exemplarily, with reference to FIG. 3A, the bonding assembly may include two first optical paths 302 arranged in parallel along the x direction. The first alignment assembly 304 includes two aligners 3041 and two second optical paths 306 arranged in parallel along the x direction. Each aligner 3041 is aligned with one of the first optical paths 302 through one of the second optical paths 306.

It to be noted that the bonding assembly including two first optical paths, and the first alignment assembly including two aligners and two second optical paths are shown in this example. In other examples, the bonding assembly may include at least three first optical paths, and the first alignment assembly may include at least three aligners and three second optical paths.

For example, based on what shown in FIG. 3A, the bonding assembly further includes two first optical paths arranged in parallel along the y direction, the first alignment assembly further includes two aligners arranged in parallel along the y direction and two second optical paths arranged in parallel along the y direction. In this way, the bonding assembly is provided with four first optical paths, the first alignment assembly is provided with four aligners and four second optical paths. Each aligner is aligned with one of the first optical paths through one of the second optical paths.

Here, the number or positions of arranging the first optical paths in the bonding assembly and the number or positions of arranging the aligners in the first bonding assembly may be set according to the number or positions of the calibration marks in the first to-be-bonded die, and are not further limited by the present disclosure.

Compared with one aligner configured to align with at least two first optical paths, two aligners are arranged in the embodiments of the present disclosure, so that one of the aligners may be aligned with one of the first optical paths through one of the second optical paths. Each aligner may locate each positioning mark independently, which is conducive to improving accuracy of locating the positioning mark.

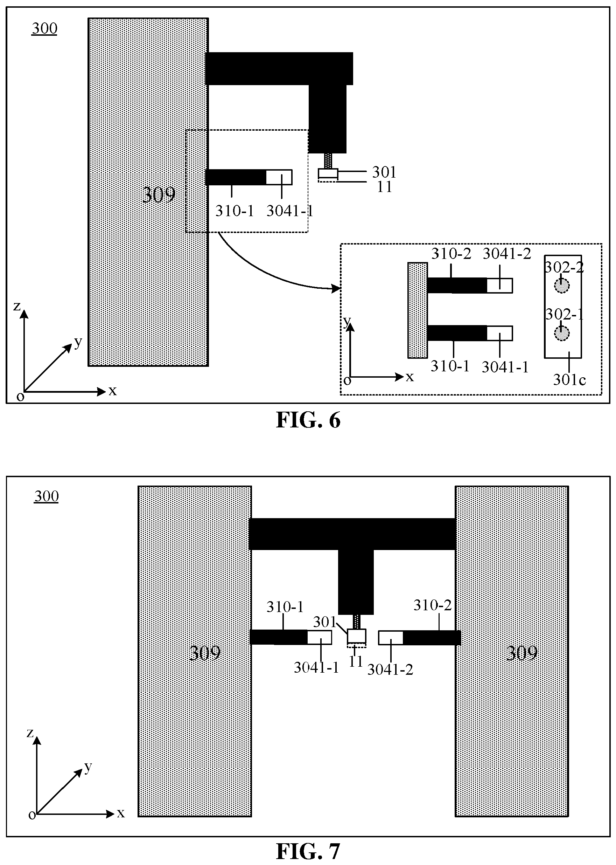

In some embodiments, with reference to FIG. 3A and FIG. 6, the bonding system 300 further includes a base 309, a first bracket 310-1 and a second bracket 310-2.

The base 309 is located on the side surface 301c of the bonding head 301.

The first bracket 310-1 is arranged parallel to the picking surface 301b and is configured to fixedly connect a first aligner 3041-1 to the base 309.

The second bracket 310-2 is arranged parallel to the picking surface 301b and is configured to fixedly connect a second aligner 3041-2 to the base 309.

FIG. 6 shows a top view of a part of the bonding system 300 in an xoy plane. The bonding assembly may include the 1^{st} first optical path 302-1 and the 2^{nd} first optical path 302-2 arranged in parallel along the y direction. The first alignment assembly may include the first aligner 3041-1 and the second aligner 3041-2 arranged in parallel along the y direction. When the bonding assembly is located at the first position, the first aligner 3041-1 is aligned with the 1^{st} first optical path 302-1, and the second aligner 3041-2 is aligned with the 2^{nd} first optical path 302-2.

The first aligner 3041-1 is fixedly connected to the base 309 through the first bracket 310-1, and the second aligner 3041-2 is fixedly connected to the base 309 through the second bracket 310-2. It may be understood that projections of the first aligner 3041-1 and the second aligner 3041-2 in an xoz plane coincide, that is, the first aligner 3041-1 and the second aligner 3041-2 are located at the same side of the bonding head 301.

In some embodiments, with reference to FIG. 3A and FIG. 7, the bonding system 300 further includes two bases 309, a first bracket 310-1 and a second bracket 310-2.

The two bases 309 are arranged at two sides of the bonding head 301 respectively.

The first bracket 310-1 is arranged parallel to the picking surface 301b and is configured to fixedly connect the first aligner 3041-1 to the first base 309.

The second bracket 310-2 is arranged parallel to the picking surface 301b and is configured to fixedly connect the second aligner 3041-2 to the second base 309.

FIG. 7 shows a schematic structural view of a part of the bonding system 300. The bonding assembly may include two first optical paths arranged in parallel along the x direction. The first alignment assembly may include the first aligner 3041-1 and the second aligner 3041-2 arranged in parallel along the x direction. When the bonding assembly is located at the first position, the first aligner 3041-1 is aligned with the first optical path at the left side of the bonding head 301, and the second aligner 3041-2 is aligned with the first optical path at the right side of the bonding head 301.

The first aligner 3041-1 is fixedly connected to the base 309 at the left side of the bonding head through the first bracket 310-1, and the second aligner 3041-2 is fixedly connected to the base 309 at the right side of the bonding head through the second bracket 310-2. The first aligner 3041-1 and the second aligner 3041-2 are located at two sides of the bonding head 301.

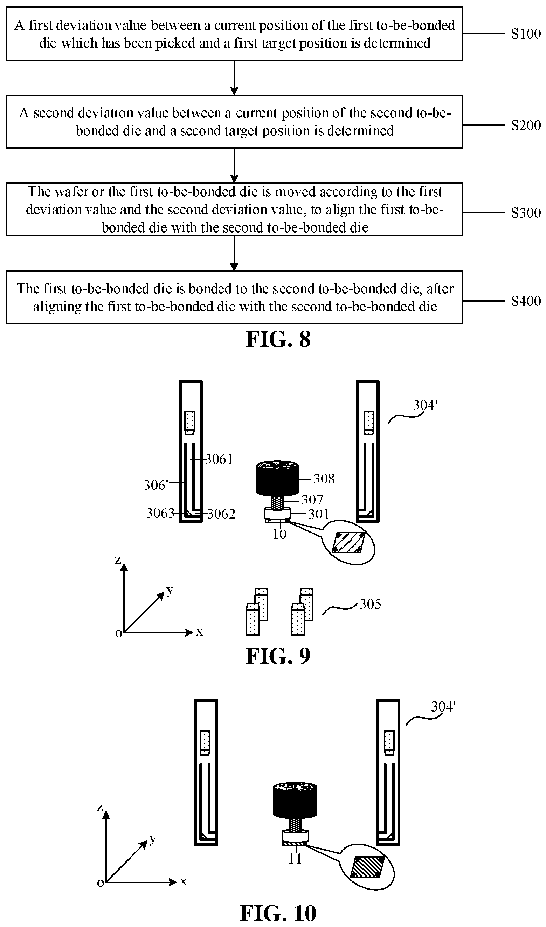

FIG. 8 shows a schematic flowchart of a bonding method according to an embodiment of the present invention. FIG. 9 to FIG. 13 show schematic views of a bonding method according to an embodiment of the present disclosure. The bonding method is applied to bond a first to-be-bonded die 11 to a second to-be-bonded die 21 on a wafer, and includes the following operations S100 to S400.

In operation S100, with reference to FIG. 10, a first deviation value between a current position of the first to-be-bonded die 11 which is picked and a first target position is determined.

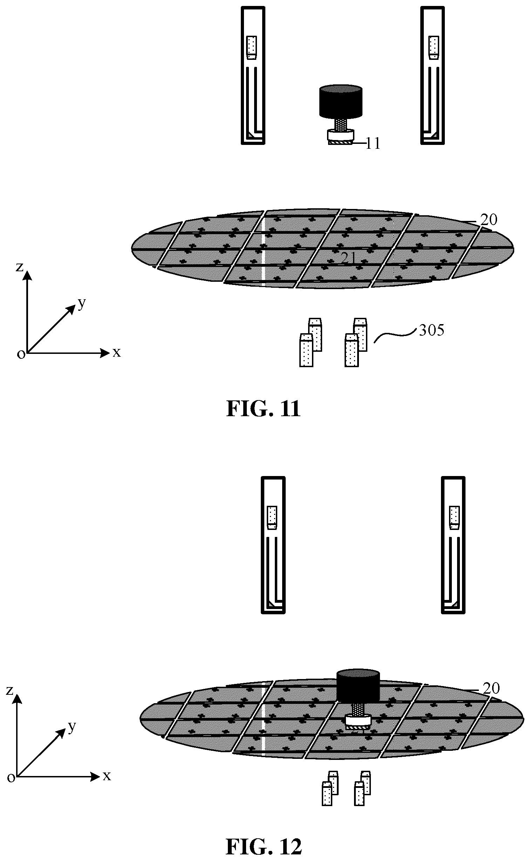

In operation S200, with reference to FIG. 11, a second deviation value between a current position of the second to-be-bonded die 21 and a second target position is determined.

In operation S300, the wafer or the first to-be-bonded die 11 is moved according to the first deviation value and the second deviation value, to align the first to-be-bonded die with the second to-be-bonded die.

In operation S400, with reference to FIG. 12, the first to-be-bonded die 11 is bonded to the second to-be-bonded die 21, after aligning the first to-be-bonded die 11 with the second to-be-bonded die 21.

In operation S100, with reference to FIG. 10, the first deviation value (Δx_{T}, Δy_{T}) between the current position (x₁, y₁) of the first to-be-bonded die 11 and the first target position (x₀, y₀) may be determined by using the first alignment assembly 304', here Δx_{T} = x₁ - xo, Δy_{T} = y₁ - y₀.

In operation S200, with reference to FIG. 11, after determining the first deviation value, the wafer 20 is transmitted to the stage, the second deviation value (Δx_{B}, Δy_{B}) between the current position (x₂, y₂) of the second to-be-bonded die 21 on the wafer 20 and the second target position (x₀', y₀') may be determined by using the second alignment assembly 305, here Δx_{B} = x₂ - xo', Δy_{T} = y₂ - y₀'.

It to be noted that the first target position and the second target position have the same position in the horizontal direction, while have different positions in the vertical direction, that is, x₀ is the same as x₀', y₀ is the same as y₀', and the first target position and the second target position have different coordinates in the z direction. Different reference numerals are only intended to facilitate distinction between the first target position and the second target position, and are not intended to limit the present disclosure.

In operation S300, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The bonding assembly may be kept fixed (that is, the first to-be-bonded die 11 is kept fixed), and the wafer 20 moves by (Δx_{T} - Δx_{B}, Δy_{T} - Δy_{B}) horizontally according to the displacement deviation, so that the second to-be-bonded die 21 is aligned with the first to-be-bonded die 11, that is, positions of the first to-be-bonded die 11 and the second to-be-bonded die 21 in the horizontal direction are the same.

Here, a direction in which the wafer 20 moves may be determined according to a positive or negative value of Δx_{T} - Δx_{B}. For example, when Δx_{T} - Δx_{B} is a negative value, the wafer 20 moves in a negative direction of x-axis, and a movement distance is an absolute value of (Δx_{T} - Δx_{B}). When Δx_{T} - Δx_{B} is a positive value, the wafer 20 moves in a positive direction of x-axis, and a movement distance is (Δx_{T} - Δx_{B}).

Similarly, a direction in which the wafer 20 moves may be determined according to a positive or negative value of Δy_{T} - Δy_{B}. For example, when Δy_{T} - Δy_{B} is a negative value, the wafer 20 moves in a negative direction of y-axis, and a movement distance is an absolute value of (Δy_{T} - Δy_{B}). When Δy_{T} - Δy_{B} is a positive value, the wafer 20 moves in a positive direction of y-axis, and a movement distance is (Δy_{T} - Δy_{B}).

In operation S300, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The wafer 20 may also be kept fixed (that is, the second to-be-bonded die 21 is kept fixed), and the first to-be-bonded die 11 moves by (Δx_{T} - Δx_{B}, Δy_{T} - Δy_{B}) horizontally according to the displacement deviation, so that the first to-be-bonded die 11 is aligned with the second to-be-bonded die 21.

Here, a direction in which the first to-be-bonded die 11 moves may be determined according to a positive or negative value of Δx_{T} - Δx_{B}. For example, when Δx_{T} - Δx_{B} is a negative value, the first to-be-bonded die 11 moves in a positive direction of x-axis, and a movement distance is an absolute value of (Δx_{T} - Δx_{B}). When Δx_{T} - Δx_{B} is a positive value, the first to-be-bonded die 11 moves in a negative direction of x-axis, and a movement distance is (Δx_{T} - Δx_{B}).

Similarly, a direction in which the first to-be-bonded die 11 moves may be determined according to a positive or negative value of Δy_{T} - Δy_{B}. For example, when Δy_{T} - Δy_{B} is a negative value, the first to-be-bonded die 11 moves in a positive direction of y-axis, and a movement distance is an absolute value of (Δy_{T} - Δy_{B}). When Δy_{T} - Δy_{B} is a positive value, the first to-be-bonded die 11 moves in a negative direction of y-axis, and a movement distance is (Δy_{T} - Δy_{B}).

In operation S300, after determining the first deviation value and the second deviation value, the wafer or the first to-be-bonded die 11 may be moved to align the first to-be-bonded die with the second to-be-bonded die. Preferably, the wafer is moved to align the second to-be-bonded die with the first to-be-bonded die.

In operation S400, with reference to FIG. 12, after aligning the first to-be-bonded die 11 with the second to-be-bonded die 21, the bonding assembly vertically moves downward, to bond the first to-be-bonded die 11 to the second to-be-bonded die 21.

It should be emphasized that the first to-be-bonded die 11 is a die independent of the wafer. In the process of manufacturing semiconductor devices, multiple dies are usually formed on the wafer. Here, the first to-be-bonded die 11 refers to an independent die formed after the wafer carrying multiple dies is cut. It may be understood that the first to-be-bonded die has a size much less than that of the wafer.

In the embodiments of the present disclosure, the first deviation value between the current position of the first to-be-bonded die and the first target position is determined, the second deviation value between the current position of the second to-be-bonded die on the wafer and the second target position is determined, and the wafer or the first to-be-bonded die is adjusted according to the first deviation value and the second deviation value, which may align the first to-be-bonded die with the second to-be-bonded die accurately, and is conducive to improving accuracy of die to wafer bonding.

In some embodiments, the bonding method is applied to the bonding system 300 in any one of the above embodiments, and with reference to FIG. 9, the bonding method further includes the following operations.

A calibration die 10 is provided, here the calibration die 10 includes a first surface and a second surface arranged opposite to each other, a first positioning mark located on the first surface, and a second positioning mark located on the second surface, and projections of the first positioning mark and the second positioning mark on the first surface coincide in a direction perpendicular to the first surface.

The calibration die 10 is picked, here a picking surface contacts the first surface of the calibration die, and a first end of the first optical path covers the first positioning mark.

A position of the first alignment assembly 304' is kept unchanged, and a bonding head 301 picking the calibration die is moved, until the first alignment assembly 304' identifies the first positioning mark, here a position of the calibration die is determined as the first target position, when the first alignment assembly 304' identifies the first positioning mark.

The second alignment assembly 305 is moved when the calibration die is located at the first target position, until the second alignment assembly 305 identifies the second positioning mark, here the first alignment assembly 304' and the second alignment assembly 305 are determined to be located at reference positions, when the second alignment assembly 305 identifies the second positioning mark.

The first alignment assembly 304' and the second alignment assembly 305 are kept located at the reference positions, and operations of determining the first deviation value and determining the second deviation value are performed.

Exemplarily, with reference to FIG. 9, the calibration die 10 is provided, the calibration die 10 includes a first surface and a second surface arranged opposite to each other in the z direction, the first surface is provided with a first positioning mark, and the second surface is provided with a second positioning mark, and projections of the first positioning mark and the second positioning mark in the xoy plane coincide. The calibration die 10 may be a standard die for calibration, or a first die in a batch of dies bonded to the wafer.

Each of the first positioning mark and the second positioning mark has a "+" shape, "L" shape, or the like. For example, FIG. 9 shows that the first surface of the calibration die 10 is provided with four first positioning marks with "+" shape. It should be understood that the second surface of the calibration die 10 is also provided with four second positioning marks with "+" shape, and projections of each second positioning mark and each first positioning mark in the xoy plane coincide.

Exemplarily, with reference to FIG. 4A and FIG. 9, the calibration die 10 is picked by using the bonding head 301 of the bonding assembly. Specifically, a position of the mobile unit 308 is adjusted so that the picking surface 301b of the bonding head 301 contacts the first surface of the calibration die 10. When the picking surface 301b of the bonding head 301 contacts the calibration die 10, the first end 302a of the first optical path 302 exposes the first positioning mark on the first surface.

Exemplarily, with reference to FIG. 4A and FIG. 9, a position of the first alignment assembly 304' is kept unchanged, and the bonding assembly is moved in the horizontal direction (such as x or y direction) and/or the vertical direction (such as z direction), until the second end 302b of the first optical path 302 is aligned with the second sub-path 3062 of the second optical path 306'.

Exemplarily, with reference to FIG. 4B and FIG. 9, the first alignment assembly 304' transmits a detection optical signal, the detection optical signal is transmitted to the first positioning mark of the first to-be-bonded die 11 through the second optical path 306' and the first optical path 302, and forms a reflection optical signal, the reflection optical signal is transmitted to the first alignment assembly 304' through the first optical path 302 and the second optical path 306'. After receiving the reflection optical signal, the first alignment assembly 304' may determine the current position of the calibration die 10 as the first target position (x₀, y₀) according to the reflection optical signal.

After determining the first target position, positions of the first alignment assembly 304', the bonding assembly and the calibration die 10 are kept unchanged, and the second alignment assembly 305 moves in the horizontal direction (such as x or y direction), until the second alignment assembly 305 identifies the second positioning mark on the second surface. At this time, the first alignment assembly 304' may identify the first positioning mark on the first surface, the second alignment assembly 305 may identify the second positioning mark on the second surface, it is determined that the first alignment assembly 304' and the second alignment assembly 305 are located at the reference positions, calibration is completed, and operations of determining the first deviation value and determining the second deviation value are performed.

It may be understood that in the embodiments of the present disclosure, the first positioning mark on the first surface of the calibration die is identified by the first alignment assembly, and then the second positioning mark on the second surface of the calibration die is identified by the second alignment assembly. Since projections of the first positioning mark and the second positioning mark in the xoy plane coincide, positions where the first alignment assembly and the second alignment assembly are located at this time may be determined as the reference positions, which is conducive to providing reference positions for alignment before die to wafer bonding.

In some embodiments, the bonding method is applied to the bonding system 300 in any one of the above embodiments, and with reference to FIG. 9, the bonding method further includes the following operations.

A calibration die 10 is provided, here the calibration die 10 includes a first surface and a second surface arranged opposite to each other, a first positioning mark located on the first surface, and a second positioning mark located on the second surface, and projections of the first positioning mark and the second positioning mark on the first surface coincide in a direction perpendicular to the first surface.

The calibration die 10 is picked, here a picking surface contacts the first surface of the calibration die, and a first end of the first optical path covers the first positioning mark.

A position of the second alignment assembly 305 is kept unchanged, and a picking surface picking the calibration die is moved, until the second alignment assembly 305 identifies the second positioning mark, here a position of the calibration die is determined as the first target position, when the second alignment assembly 305 identifies the second positioning mark.

The first alignment assembly 304' is moved when the calibration die 10 is located at the first target position, until the first alignment assembly 304' identifies the first positioning mark, here the first alignment assembly 304' and the second alignment assembly 305 are determined to be located at reference positions, when the first alignment assembly 304' identifies the first positioning mark.

The first alignment assembly 304' and the second alignment assembly 305 are kept located at the reference positions, and operations of determining the first deviation value and determining the second deviation value are performed.

Exemplarily, with reference to FIG. 4A and FIG. 9, the calibration die 10 is picked by using the bonding head 301 of the bonding assembly. Specifically, a position of the mobile unit 308 is adjusted so that the picking surface 301b of the bonding head 301 contacts the first surface of the calibration die 10. When the picking surface 301b of the bonding head 301 contacts the calibration die 10, the first end 302a of the first optical path 302 exposes the first positioning mark on the first surface.

Exemplarily, with reference to FIG. 4A and FIG. 9, a position of the second alignment assembly 305 is kept unchanged, and the bonding assembly is moved in the horizontal direction (such as x or y direction), until the second alignment assembly 305 identifies the second positioning mark on the second surface. At this time, the current position of the calibration die 10 may be determined as the first target position (x₀, y₀).

After determining the first target position, positions of the second alignment assembly 305, the bonding assembly and the calibration die 10 are kept unchanged, and the first alignment assembly 304' moves in the horizontal direction (such as x or y direction) and/or the vertical direction (such as z direction), until the second end 302b of the first optical path 302 is aligned with the second sub-path 3062 of the second optical path 306'.

Exemplarily, with reference to FIG. 4B and FIG. 9, the first alignment assembly 304' transmits a detection optical signal, the detection optical signal is transmitted to the first positioning mark of the first to-be-bonded die 11 through the second optical path 306' and the first optical path 302, and forms a reflection optical signal, the reflection optical signal is transmitted to the first alignment assembly 304' through the first optical path 302 and the second optical path 306'.

At this time, the first alignment assembly 304' may identify the first positioning mark on the first surface, the second alignment assembly 305 may identify the second positioning mark on the second surface, it is determined that the first alignment assembly 304' and the second alignment assembly 305 are located at the reference positions, calibration is completed, and operations of determining the first deviation value and determining the second deviation value are performed.

It may be understood that in the embodiments of the present disclosure, the second positioning mark on the second surface of the calibration die is identified by the second alignment assembly, and then the first positioning mark on the first surface of the calibration die is identified by the first alignment assembly. Since projections of the first positioning mark and the second positioning mark in the xoy plane coincide, positions where the first alignment assembly and the second alignment assembly are located at this time may be determined as the reference positions, which is conducive to providing reference positions for alignment before die to wafer bonding.

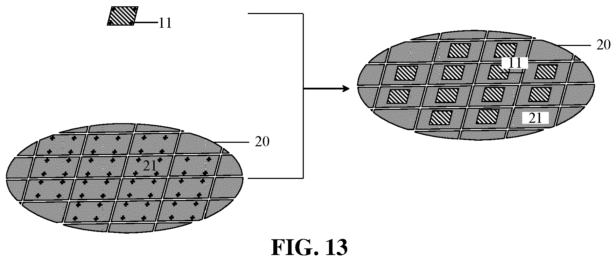

FIG. 13 shows a schematic view of a die to wafer structure according to an embodiment of the present disclosure. The die to wafer structure is manufactured by applying the bonding system 300 in any one of the above embodiments and the bonding method in any one of the above embodiments, and includes multiple first dies 11 and a wafer 20.

The wafer 20 includes multiple second dies 21, here each first die 11 is bonded to each second die 21.

It is apparent that the above embodiments are merely examples made for clear explanation, rather than limiting the implementations. Other changes or variations in different forms may also be made by those ordinary skilled in the art based on the above descriptions. It is unnecessary and impossible to enumerate all the implementations here. Apparent changes or variations arising therefrom still fall within the scope of the invention defined by the appended claims.

## Claims

1. A bonding system (300), comprising:
a bonding assembly (300) comprising a bonding head (301) configured to pick a first to-be-bonded die (11) and a first optical path (302) passing through the bonding head (301), wherein a first end of the first optical path (302) is located at a picking surface where the bonding head (301) picks the first to-be-bonded die (11);
a wafer stage (303) configured to carry a wafer (20);
a first alignment assembly (304) configured to transmit a detection optical signal to the first end (302a) via a second end (302b) of the first optical path (302), when the bonding assembly is located at a first position, wherein the picked first to-be-bonded die (11) covers the first end (302a) and reflects the detection optical signal;
wherein the first alignment assembly (304) is further configured to receive a reflection optical signal generated by the first to-be-bonded die (11) reflecting the detection optical signal, and determine a first deviation value between a current position of the first to-be-bonded die (11) and a first target position according to the received reflection optical signal; **characterized by**
a second alignment assembly (305) located at a side of the wafer stage (303) away from the bonding assembly, and configured to determine a second deviation value between a current position of a second to-be-bonded die (21) on the wafer (20) and a second target position;
wherein the wafer stage (303) is further configured to drive, according to the first deviation value and the second deviation value, the carried wafer (20) to move relative to the picking surface (301b), to align the second to-be-bonded die (21) with the first to-be-bonded die (11); or the bonding assembly further configured to drive, according to the first deviation value and the second deviation value, the picking surface (301b) where the first to-be-bonded die (11) is picked to move relative to the wafer stage (303), to align the first to-be-bonded die (11) with the second to-be-bonded die (21); and
the bonding assembly is further configured to bond the first to-be-bonded die (11) to the second to-be-bonded die (21);
wherein
the bonding head (301) comprises a side surface (301c) which is perpendicular to the picking surface (301b) and in which the second end (302b) of the first optical path (302) is arranged;
the first optical path (302) comprises a first reflector (3021) configured to reflect an optical signal transmitted between the first end (302a) of the first optical path (302) and the second end (302b) of the first optical path (302);
the first alignment assembly (304) comprises: a second optical path (306), and an aligner (3041) which is configured to transmit the detection optical signal, to receive the reflection optical signal, and to determine the first deviation value;
wherein when the bonding assembly is located at the first position, the aligner (3041) is located at an end of the second optical path (306) away from the side surface, and another end of the second optical path (306) close to the side surface (301c) is aligned with the second end (302b) of the first optical path (302).

2. The bonding system (300) of claim 1, wherein
the second optical path (306) is parallel to the picking surface (301b), when the bonding assembly is located at the first position.

3. The bonding system (300) of claim 1, wherein
the second optical path (306) comprises: a first sub-path (3061), a second sub-path (3062) perpendicular to the first sub-path (3061), and a second reflector (3063) located at intersection of the first sub-path (3061) and the second sub-path (3062) and configured to reflect an optical signal transmitted between the first sub-path (3061) and the second sub-path (3062);
the aligner (3041) is located at an end of the first sub-path (3061) away from the second sub-path (3062);
wherein when the bonding assembly is located at the first position, the first sub-path (3061) is perpendicular to the picking surface (301b), the second sub-path (3062) is parallel to the picking surface (301b), and an end of the second sub-path (3062) close to the side surface (301c) is aligned with the second end (302b) of the first optical path (302).

4. The bonding system (300) of claim 1, wherein
the bonding head (301) further comprises a top surface parallel to the picking surface (301b), the top surface comprising a first area and a second area;
the bonding assembly further comprises: a mobile unit (308) configured to move the bonding head (301) relative to the wafer stage (303), and a fixation unit fixedly connecting the first area to the mobile unit (308);
the first optical path (302) passes through the bonding head (301) in a direction perpendicular to the picking surface (301b), wherein a second end (302b) of the first optical path (302) is located in the second area;
the first alignment assembly (304) with a projection in a horizontal direction located in the second area, comprises a second optical path (306) and an aligner (3041), the aligner (3041) is configured to transmit the detection optical signal, to receive the reflection optical signal, and to determine the first deviation value;
wherein the second optical path (306) is perpendicular to the picking surface (301b) and is aligned with the first optical path (302), the aligner (3041) is located at an end of the second optical path (306) away from the bonding head (301).

5. The bonding system (300) of any one of claims 1 to 4, wherein
the bonding assembly comprises two first optical paths (302), in which first ends (302a) of different first optical paths (302) are arranged in different positions, and second ends (302b) of different first optical paths (302) are arranged in different positions on the picking surface (301b);
the first alignment assembly (304) comprises one aligner (3041), and when the bonding assembly is located at the first position, the aligner (3041) is aligned with a second end (302b) of one of the first optical paths (302);
the bonding assembly further comprises a driving unit configured to drive the two first optical paths (302) to move relative to the aligner (3041), so that the aligner (3041) is aligned with a second end (302b) of the other of the first optical paths (302).

6. The bonding system (300) of any one of claims 1 to 3, wherein
the bonding assembly comprises two first optical paths (302), in which first ends (302a) of different first optical paths (302) are arranged in different positions, and second ends (302b) of different first optical paths (302) are arranged in different positions on the picking surface (301b);
the first alignment assembly (304) comprises two aligners (3041) and two second optical paths (306), in which different aligners (3041) are located at ends of different second optical paths (306) away from the bonding head (301);
wherein different second optical paths (306) are aligned with different first optical paths (302), when the bonding assembly is located at the first position.

7. The bonding system (300) of claim 6, further comprising:
a base (309) located on the side surface (301c) of the bonding head (301);
a first bracket (310-1) arranged parallel to the picking surface (301b) and configured to fixedly connect a first one of the aligners (3041) to the base; and
a second bracket (310-2) arranged parallel to the picking surface (301b) and configured to fixedly connect a second one of the aligners (3041) to the base.

8. The bonding system (300) of claim 6, further comprising:
two bases (309) arranged at two sides of the bonding head (301) respectively;
a first bracket (310-1) arranged parallel to the picking surface (301b) and configured to fixedly connect a first one of the aligners (3041) to a first one of the bases (309); and
a second bracket (310-2) arranged parallel to the picking surface (301b) and configured to fixedly connect a second one of the aligners (3041) to a second one of the bases (309).

9. A bonding method, applied to bond a first to-be-bonded die to a second to-be-bonded die on a wafer, comprising:
determining (S100), by a first alignment assembly, a first deviation value between a current position of the first to-be-bonded die which is picked and a first target position;
determining (S200), by a second alignment assembly, a second deviation value between a current position of the second to-be-bonded die and a second target position;
moving (S300), by a wafer stage, the wafer or moving, by a bonding assembly, the first to-be-bonded die according to the first deviation value and the second deviation value, to align the first to-be-bonded die with the second to-be-bonded die; and
bonding (S400), by the bonding assembly, the first to-be-bonded die to the second to-be-bonded die, after aligning the first to-be-bonded die with the second to-be-bonded die;
wherein determining (S100), by the first alignment assembly, the first deviation value between the current position of the first to-be-bonded die which is picked and the first target position comprises:
when the bonding assembly is located at a first position, transmitting, by an aligner in the first alignment assembly, a detection optical signal to a first end of a first optical path via a second end of the first optical path;
reflecting, by a first reflector in the first optical path, the detection optical signal;
receiving, by the aligner, a reflection optical signal;
determining, by the aligner, the first deviation value;
wherein a bonding head configured to pick the first to-be-bonded die comprises a side surface perpendicular to a picking surface, and the second end of the first optical path is arranged in the side surface;
wherein when the bonding assembly is located at the first position, the aligner is located at an end of a second optical path in the first alignment assembly away from the side surface, and another end of the second optical path close to the side surface is aligned with the second end of the first optical path.

10. The bonding method of claim 9, applied to the bonding system of any one of claims 1 to 8, further comprising:
providing a calibration die comprising a first surface and a second surface arranged opposite to each other, a first positioning mark located on the first surface, and a second positioning mark located on the second surface, and projections of the first positioning mark and the second positioning mark on the first surface coinciding in a direction perpendicular to the first surface;
picking the calibration die, wherein a picking surface contacts the first surface of the calibration die, and the first end of the first optical path covers the first positioning mark;
keeping a position of the first alignment assembly unchanged, and moving the bonding head picking the calibration die, until the first positioning mark is identified by the first alignment assembly, wherein a position of the calibration die is determined as the first target position, when the first positioning mark is identified by the first alignment assembly;
moving the second alignment assembly when the calibration die is located at the first target position, until the second positioning mark is identified by the second alignment assembly, wherein the first alignment assembly and the second alignment assembly are determined to be located at reference positions, when the second positioning mark is identified by the second alignment assembly; and
keeping the first alignment assembly and the second alignment assembly located at the reference positions, and performing operations of determining the first deviation value and determining the second deviation value.

11. The bonding method of claim 9, applied to the bonding system of any one of claims 1 to 8, further comprising:
providing a calibration die comprising: a first surface and a second surface arranged opposite to each other, a first positioning mark located on the first surface, and a second positioning mark located on the second surface, and projections of the first positioning mark and the second positioning mark on the first surface coinciding in a direction perpendicular to the first surface;
picking the calibration die, wherein a picking surface contacts the first surface of the calibration die, and the first end of the first optical path covers the first positioning mark;
keeping a position of the second alignment assembly unchanged, and moving a picking surface picking the calibration die, until the second positioning mark is identified by the second alignment assembly, wherein a position of the calibration die is determined as the first target position, when the second positioning mark is identified by the second alignment assembly;
moving the first alignment assembly when the calibration die is located at the first target position, until the first positioning mark is identified by the first alignment assembly, wherein the first alignment assembly and the second alignment assembly are determined to be located at reference positions, when the first positioning mark is identified by the first alignment assembly; and
keeping the first alignment assembly and the second alignment assembly located at the reference positions, and performing operations of determining the first deviation value and determining the second deviation value.

## Patentansprüche

1. Bondsystem (300), umfassend:
eine Bondanordnung (300), die einen Bondkopf (301) umfasst, der dazu konfiguriert ist, einen ersten zu bondenden Chip (11) aufzunehmen, und einen ersten optischen Pfad (302), der durch den Bondkopf (301) verläuft, wobei ein erstes Ende des ersten optischen Pfades (302) an einer Aufnahmefläche angeordnet ist, an der der Bondkopf (301) den ersten zu bondenden Chip (11) aufnimmt;
einen Wafertisch (303), der dazu konfiguriert ist, einen Wafer (20) zu tragen;
eine erste Ausrichtungsanordnung (304), die dazu konfiguriert ist, ein optisches Detektionssignal an das erste Ende (302a) über ein zweites Ende (302b) des ersten optischen Pfades (302) zu übertragen, wenn sich die Bondanordnung in einer ersten Position befindet, wobei der aufgenommene erste zu bondende Chip (11) das erste Ende (302a) bedeckt und das optische Detektionssignal reflektiert;
wobei die erste Ausrichtungsanordnung (304) ferner dazu konfiguriert ist, ein optisches Reflexionssignal, das durch den ersten zu bondenden Chip (11) erzeugt wird, der das optische Detektionssignal reflektiert, zu empfangen und einen ersten Abweichungswert zwischen einer aktuellen Position des ersten zu bondenden Chips (11) und einer ersten Zielposition gemäß dem empfangenen optischen Reflexionssignal zu bestimmen;
**gekennzeichnet durch** eine zweite Ausrichtungsanordnung (305), die an einer Seite des Wafertisches (303) angeordnet ist, die von der Bondanordnung abgewandt ist, und die dazu konfiguriert ist, einen zweiten Abweichungswert zwischen einer aktuellen Position eines zweiten zu bondenden Chips (21) auf dem Wafer (20) und einer zweiten Zielposition zu bestimmen;
wobei der Wafertisch (303) ferner dazu konfiguriert ist, gemäß dem ersten Abweichungswert und dem zweiten Abweichungswert den getragenen Wafer (20) dazu anzutreiben, sich relativ zur Aufnahmefläche (301b) zu bewegen, um den zweiten zu bondenden Chip (21) mit dem ersten zu bondenden Chip (11) auszurichten; oder die Bondanordnung ferner dazu konfiguriert ist, gemäß dem ersten Abweichungswert und dem zweiten Abweichungswert die Aufnahmefläche (301b), an der der erste zu bondende Chip (11) aufgenommen wird, dazu anzutreiben, sich relativ zum Wafertisch (303) zu bewegen, um den ersten zu bondenden Chip (11) mit dem zweiten zu bondenden Chip (21) auszurichten; und
die Bondanordnung ferner dazu konfiguriert ist, den ersten zu bondenden Chip (11) mit dem zweiten zu bondenden Chip (21) zu bonden;
wobei
der Bondkopf (301) eine Seitenfläche (301c) umfasst, die senkrecht zur Aufnahmefläche (301b) ist und in der das zweite Ende (302b) des ersten optischen Pfades (302) angeordnet ist;
der erste optische Pfad (302) einen ersten Reflektor (3021) umfasst, der dazu konfiguriert ist, ein optisches Signal, das zwischen dem ersten Ende (302a) des ersten optischen Pfades (302) und dem zweiten Ende (302b) des ersten optischen Pfades (302) übertragen wird, zu reflektieren;
die erste Ausrichtungsanordnung (304) umfasst: einen zweiten optischen Pfad (306) und einen Ausrichter (3041), der dazu konfiguriert ist, das optische Detektionssignal zu übertragen, das optische Reflexionssignal zu empfangen und den ersten Abweichungswert zu bestimmen;
wobei, wenn sich die Bondanordnung in der ersten Position befindet, der Ausrichter (3041) an einem Ende des zweiten optischen Pfades (306) angeordnet ist, das von der Seitenfläche entfernt ist, und ein anderes Ende des zweiten optischen Pfades (306), das nahe der Seitenfläche (301c) liegt, mit dem zweiten Ende (302b) des ersten optischen Pfades (302) ausgerichtet ist.

2. Bondsystem (300) nach Anspruch 1, wobei
der zweite optische Pfad (306) parallel zur Aufnahmefläche (301b) ist, wenn sich die Bondanordnung in der ersten Position befindet.

3. Bondsystem (300) nach Anspruch 1, wobei
der zweite optische Pfad (306) umfasst: einen ersten Unterpfad (3061), einen zweiten Unterpfad (3062), der senkrecht zum ersten Unterpfad (3061) ist, und einen zweiten Reflektor (3063), der am Schnittpunkt des ersten Unterpfades (3061) und des zweiten Unterpfades (3062) angeordnet ist und dazu konfiguriert ist, ein optisches Signal, das zwischen dem ersten Unterpfad (3061) und dem zweiten Unterpfad (3062) übertragen wird, zu reflektieren;
der Ausrichter (3041) an einem Ende des ersten Unterpfades (3061) angeordnet ist, das vom zweiten Unterpfad (3062) entfernt ist;
wobei, wenn sich die Bondanordnung in der ersten Position befindet, der erste Unterpfad (3061) senkrecht zur Aufnahmefläche (301b) ist, der zweite Unterpfad (3062) parallel zur Aufnahmefläche (301b) ist und ein Ende des zweiten Unterpfades (3062), das nahe der Seitenfläche (301c) liegt, mit dem zweiten Ende (302b) des ersten optischen Pfades (302) ausgerichtet ist.

4. Bondsystem (300) nach Anspruch 1, wobei
der Bondkopf (301) ferner eine Oberfläche umfasst, die parallel zur Aufnahmefläche (301b) ist, wobei die Oberfläche einen ersten Bereich und einen zweiten Bereich umfasst;
die Bondanordnung ferner umfasst: eine mobile Einheit (308), die dazu konfiguriert ist, den Bondkopf (301) relativ zum Wafertisch (303) zu bewegen, und eine Befestigungseinheit, die den ersten Bereich fest mit der mobilen Einheit (308) verbindet;
der erste optische Pfad (302) durch den Bondkopf (301) in einer Richtung senkrecht zur Aufnahmefläche (301b) verläuft, wobei ein zweites Ende (302b) des ersten optischen Pfades (302) im zweiten Bereich angeordnet ist;
die erste Ausrichtungsanordnung (304) mit einer Projektion in horizontaler Richtung, die im zweiten Bereich angeordnet ist, einen zweiten optischen Pfad (306) und einen Ausrichter (3041) umfasst, wobei der Ausrichter (3041) dazu konfiguriert ist, das optische Detektionssignal zu übertragen, das optische Reflexionssignal zu empfangen und den ersten Abweichungswert zu bestimmen;
wobei der zweite optische Pfad (306) senkrecht zur Aufnahmefläche (301b) ist und mit dem ersten optischen Pfad (302) ausgerichtet ist, wobei der Ausrichter (3041) an einem Ende des zweiten optischen Pfades (306) angeordnet ist, das vom Bondkopf (301) entfernt ist.

5. Bondsystem (300) nach einem der Ansprüche 1 bis 4, wobei
die Bondanordnung zwei erste optische Pfade (302) umfasst, in denen erste Enden (302a) verschiedener erster optischer Pfade (302) an verschiedenen Positionen angeordnet sind und zweite Enden (302b) verschiedener erster optischer Pfade (302) an verschiedenen Positionen auf der Aufnahmefläche (301b) angeordnet sind;
die erste Ausrichtungsanordnung (304) einen Ausrichter (3041) umfasst und, wenn sich die Bondanordnung in der ersten Position befindet, der Ausrichter (3041) mit einem zweiten Ende (302b) eines der ersten optischen Pfade (302) ausgerichtet ist;
die Bondanordnung ferner eine Antriebseinheit umfasst, die dazu konfiguriert ist, die zwei ersten optischen Pfade (302) dazu anzutreiben, sich relativ zum Ausrichter (3041) zu bewegen, so dass der Ausrichter (3041) mit einem zweiten Ende (302b) des anderen der ersten optischen Pfade (302) ausgerichtet ist.

6. Bondsystem (300) nach einem der Ansprüche 1 bis 3, wobei
die Bondanordnung zwei erste optische Pfade (302) umfasst, in denen erste Enden (302a) verschiedener erster optischer Pfade (302) an verschiedenen Positionen angeordnet sind und zweite Enden (302b) verschiedener erster optischer Pfade (302) an verschiedenen Positionen auf der Aufnahmefläche (301b) angeordnet sind;
die erste Ausrichtungsanordnung (304) zwei Ausrichter (3041) und zwei zweite optische Pfade (306) umfasst, in denen verschiedene Ausrichter (3041) an Enden verschiedener zweiter optischer Pfade (306) angeordnet sind, die vom Bondkopf (301) entfernt sind;
wobei verschiedene zweite optische Pfade (306) mit verschiedenen ersten optischen Pfaden (302) ausgerichtet sind, wenn sich die Bondanordnung in der ersten Position befindet.

7. Bondsystem (300) nach Anspruch 6, ferner umfassend:
eine Basis (309), die auf der Seitenfläche (301c) des Bondkopfes (301) angeordnet ist; einen ersten Halter (310-1), der parallel zur Aufnahmefläche (301b) angeordnet ist und dazu konfiguriert ist, einen ersten der Ausrichter (3041) fest mit der Basis zu verbinden; und
einen zweiten Halter (310-2), der parallel zur Aufnahmefläche (301b) angeordnet ist und dazu konfiguriert ist, einen zweiten der Ausrichter (3041) fest mit der Basis zu verbinden.

8. Bondsystem (300) nach Anspruch 6, ferner umfassend:
zwei Basen (309), die an zwei Seiten des Bondkopfes (301) jeweils angeordnet sind;
einen ersten Halter (310-1), der parallel zur Aufnahmefläche (301b) angeordnet ist und dazu konfiguriert ist, einen ersten der Ausrichter (3041) fest mit einer ersten der Basen (309) zu verbinden; und
einen zweiten Halter (310-2), der parallel zur Aufnahmefläche (301b) angeordnet ist und dazu konfiguriert ist, einen zweiten der Ausrichter (3041) fest mit einer zweiten der Basen (309) zu verbinden.

9. Bondverfahren, angewandt zum Bonden eines ersten zu bondenden Chips auf einen zweiten zu bondenden Chip auf einem Wafer, umfassend:
Bestimmen (S100), durch eine erste Ausrichtungsanordnung, eines ersten Abweichungswertes zwischen einer aktuellen Position des ersten zu bondenden Chips, der aufgenommen ist, und einer ersten Zielposition;
Bestimmen (S200), durch eine zweite Ausrichtungsanordnung, eines zweiten Abweichungswertes zwischen einer aktuellen Position des zweiten zu bondenden Chips und einer zweiten Zielposition;
Bewegen (S300), durch einen Wafertisch, des Wafers oder Bewegen, durch eine Bondanordnung, des ersten zu bondenden Chips gemäß dem ersten Abweichungswert und dem zweiten Abweichungswert, um den ersten zu bondenden Chip mit dem zweiten zu bondenden Chip auszurichten; und
Bonden (S400), durch die Bondanordnung, des ersten zu bondenden Chips auf den zweiten zu bondenden Chip, nach dem Ausrichten des ersten zu bondenden Chips mit dem zweiten zu bondenden Chip;
wobei das Bestimmen (S100), durch die erste Ausrichtungsanordnung, des ersten Abweichungswertes zwischen der aktuellen Position des ersten zu bondenden Chips, der aufgenommen ist, und der ersten Zielposition umfasst:
wenn sich die Bondanordnung in einer ersten Position befindet, Übertragen, durch einen Ausrichter in der ersten Ausrichtungsanordnung, eines optischen Detektionssignals an ein erstes Ende eines ersten optischen Pfades über ein zweites Ende des ersten optischen Pfades;
Reflektieren, durch einen ersten Reflektor im ersten optischen Pfad, des optischen Detektionssignals;
Empfangen, durch den Ausrichter, eines optischen Reflexionssignals;
Bestimmen, durch den Ausrichter, des ersten Abweichungswertes;
wobei ein Bondkopf, der dazu konfiguriert ist, den ersten zu bondenden Chip aufzunehmen, eine Seitenfläche umfasst, die senkrecht zu einer Aufnahmefläche ist, und das zweite Ende des ersten optischen Pfades in der Seitenfläche angeordnet ist;
wobei, wenn sich die Bondanordnung in der ersten Position befindet, der Ausrichter an einem Ende eines zweiten optischen Pfades in der ersten Ausrichtungsanordnung angeordnet ist, das von der Seitenfläche entfernt ist, und ein anderes Ende des zweiten optischen Pfades, das nahe der Seitenfläche liegt, mit dem zweiten Ende des ersten optischen Pfades ausgerichtet ist.

10. Bondverfahren nach Anspruch 9, angewandt auf das Bondsystem nach einem der Ansprüche 1 bis 8, ferner umfassend:
Bereitstellen eines Kalibrierchips, der eine erste Oberfläche und eine zweite Oberfläche umfasst, die einander gegenüberliegend angeordnet sind, eine erste Positionierungsmarke, die auf der ersten Oberfläche angeordnet ist, und eine zweite Positionierungsmarke, die auf der zweiten Oberfläche angeordnet ist, und wobei Projektionen der ersten Positionierungsmarke und der zweiten Positionierungsmarke auf die erste Oberfläche in einer Richtung senkrecht zur ersten Oberfläche zusammenfallen;
Aufnehmen des Kalibrierchips, wobei eine Aufnahmefläche die erste Oberfläche des Kalibrierchips kontaktiert und das erste Ende des ersten optischen Pfades die erste Positionierungsmarke bedeckt;
Beibehalten einer Position der ersten Ausrichtungsanordnung unverändert und Bewegen des Bondkopfes, der den Kalibrierchip aufnimmt, bis die erste Positionierungsmarke durch die erste Ausrichtungsanordnung identifiziert wird, wobei eine Position des Kalibrierchips als die erste Zielposition bestimmt wird, wenn die erste Positionierungsmarke durch die erste Ausrichtungsanordnung identifiziert wird;
Bewegen der zweiten Ausrichtungsanordnung, wenn sich der Kalibrierchip an der ersten Zielposition befindet, bis die zweite Positionierungsmarke durch die zweite Ausrichtungsanordnung identifiziert wird, wobei die erste Ausrichtungsanordnung und die zweite Ausrichtungsanordnung als an Referenzpositionen befindlich bestimmt werden, wenn die zweite Positionierungsmarke durch die zweite Ausrichtungsanordnung identifiziert wird; und
Beibehalten der ersten Ausrichtungsanordnung und der zweiten Ausrichtungsanordnung an den Referenzpositionen und Durchführen von Vorgängen zur Bestimmung des ersten Abweichungswertes und zur Bestimmung des zweiten Abweichungswertes.

11. Bondverfahren nach Anspruch 9, angewandt auf das Bondsystem nach einem der Ansprüche 1 bis 8, ferner umfassend:
Bereitstellen eines Kalibrierchips, umfassend: eine erste Oberfläche und eine zweite Oberfläche, die einander gegenüberliegend angeordnet sind, eine erste Positionierungsmarke, die auf der ersten Oberfläche angeordnet ist, und eine zweite Positionierungsmarke, die auf der zweiten Oberfläche angeordnet ist, und wobei Projektionen der ersten Positionierungsmarke und der zweiten Positionierungsmarke auf die erste Oberfläche in einer Richtung senkrecht zur ersten Oberfläche zusammenfallen;
Aufnehmen des Kalibrierchips, wobei eine Aufnahmefläche die erste Oberfläche des Kalibrierchips kontaktiert und das erste Ende des ersten optischen Pfades die erste Positionierungsmarke bedeckt;
Beibehalten einer Position der zweiten Ausrichtungsanordnung unverändert und Bewegen einer Aufnahmefläche, die den Kalibrierchip aufnimmt, bis die zweite Positionierungsmarke durch die zweite Ausrichtungsanordnung identifiziert wird, wobei eine Position des Kalibrierchips als die erste Zielposition bestimmt wird, wenn die zweite Positionierungsmarke durch die zweite Ausrichtungsanordnung identifiziert wird;
Bewegen der ersten Ausrichtungsanordnung, wenn sich der Kalibrierchip an der ersten Zielposition befindet, bis die erste Positionierungsmarke durch die erste Ausrichtungsanordnung identifiziert wird, wobei die erste Ausrichtungsanordnung und die zweite Ausrichtungsanordnung als an Referenzpositionen befindlich bestimmt werden, wenn die erste Positionierungsmarke durch die erste Ausrichtungsanordnung identifiziert wird; und
Beibehalten der ersten Ausrichtungsanordnung und der zweiten Ausrichtungsanordnung an den Referenzpositionen und Durchführen von Vorgängen zur Bestimmung des ersten Abweichungswertes und zur Bestimmung des zweiten Abweichungswertes.

## Revendications

1. Système de liaison (300), comprenant :
un ensemble de liaison (300) comprenant une tête de liaison (301) configurée pour prélever une première puce à lier (11) et un premier chemin optique (302) passant par la tête de liaison (301), dans lequel une première extrémité du premier chemin optique (302) est située sur une surface de prélèvement où la tête de liaison (301) prélève la première puce à lier (11) ;
un porte-plaquette (303) configuré pour porter une plaquette (20) ;
un premier ensemble d'alignement (304) configuré pour transmettre un signal optique de détection à la première extrémité (302a) via une seconde extrémité (302b) du premier chemin optique (302), lorsque l'ensemble de liaison est situé dans une première position, dans lequel la première puce à lier (11) prélevée couvre la première extrémité (302a) et réfléchit le signal optique de détection ;
dans lequel le premier ensemble d'alignement (304) est en outre configuré pour recevoir un signal optique réfléchi généré par la première puce à lier (11) réfléchissant le signal optique de détection, et pour déterminer une première valeur d'écart entre une position actuelle de la première puce à lier (11) et une première position cible en fonction du signal optique réfléchi reçu ; **caractérisé par**
un second ensemble d'alignement (305) situé sur un côté du porte-plaquette (303) éloigné de l'ensemble de liaison, et configuré pour déterminer une seconde valeur d'écart entre une position actuelle d'une seconde puce à lier (21) sur la plaquette (20) et une seconde position cible ;
dans lequel le porte-plaquette (303) est en outre configuré pour entraîner, en fonction de la première valeur d'écart et de la seconde valeur d'écart, la plaquette portée (20) à se déplacer par rapport à la surface de prélèvement (301b), afin d'aligner la seconde puce à lier (21) avec la première puce à lier (11) ; ou l'ensemble de liaison est en outre configuré pour entraîner, en fonction de la première valeur d'écart et de la seconde valeur d'écart, la surface de prélèvement (301b) sur laquelle la première puce à lier (11) est prélevée, à se déplacer par rapport au porte-plaquette (303), afin d'aligner la première puce à lier (11) avec la seconde puce à lier (21) ; et
l'ensemble de liaison est en outre configuré pour lier la première puce à lier (11) à la seconde puce à lier (21) ;
dans lequel
la tête de liaison (301) comprend une surface latérale (301c) qui est perpendiculaire à la surface de prélèvement (301b) et dans laquelle est disposée la seconde extrémité (302b) du premier chemin optique (302) ;
le premier chemin optique (302) comprend un premier réflecteur (3021) configuré pour réfléchir un signal optique transmis entre la première extrémité (302a) du premier chemin optique (302) et la seconde extrémité (302b) du premier chemin optique (302) ;
le premier ensemble d'alignement (304) comprend : un second chemin optique (306) et un dispositif d'alignement (3041) qui est configuré pour transmettre le signal optique de détection, recevoir le signal optique de réflexion et déterminer la première valeur d'écart ;
dans lequel, lorsque l'ensemble de liaison est situé dans la première position, le dispositif d'alignement (3041) est situé à une extrémité du second chemin optique (306) éloignée de la surface latérale, et une autre extrémité du second chemin optique (306) proche de la surface latérale (301c) est alignée avec la seconde extrémité (302b) du premier chemin optique (302).

2. Système de liaison (300) selon la revendication 1, dans lequel
le second chemin optique (306) est parallèle à la surface de prélèvement (301b), lorsque l'ensemble de liaison est situé dans la première position.

3. Système de liaison (300) selon la revendication 1, dans lequel
le second chemin optique (306) comprend : un premier sous-chemin (3061), un second sous-chemin (3062) perpendiculaire au premier sous-chemin (3061), et un second réflecteur (3063) situé à l'intersection du premier sous-chemin (3061) et du second sous-chemin (3062) et configuré pour réfléchir un signal optique transmis entre le premier sous-chemin (3061) et le second sous-chemin (3062) ;
le dispositif d'alignement (3041) est situé à une extrémité du premier sous-chemin (3061) éloignée du second sous-chemin (3062) ;
dans lequel, lorsque l'ensemble de liaison est situé dans la première position, le premier sous-chemin (3061) est perpendiculaire à la surface de prélèvement (301b), le second sous-chemin (3062) est parallèle à la surface de prélèvement (301b), et une extrémité du second sous-chemin (3062) proche de la surface latérale (301c) est alignée avec la seconde extrémité (302b) du premier chemin optique (302).

4. Système de liaison (300) selon la revendication 1, dans lequel
la tête de liaison (301) comprend en outre une surface supérieure parallèle à la surface de prélèvement (301b), la surface supérieure comprenant une première zone et une seconde zone ;
l'ensemble de liaison comprend en outre : une unité mobile (308) configurée pour déplacer la tête de liaison (301) par rapport au porte-plaquette (303), et une unité de fixation reliant de manière fixe la première zone à l'unité mobile (308) ;
le premier chemin optique (302) passe à travers la tête de liaison (301) dans une direction perpendiculaire à la surface de prélèvement (301b), dans lequel une seconde extrémité (302b) du premier chemin optique (302) est située dans la seconde zone ;
le premier ensemble d'alignement (304) avec une projection dans une direction horizontale située dans la seconde zone, comprend un second chemin optique (306) et un dispositif d'alignement (3041), le dispositif d'alignement (3041) est configuré pour transmettre le signal optique de détection, recevoir le signal optique de réflexion et déterminer la première valeur d'écart ;
dans lequel le second chemin optique (306) est perpendiculaire à la surface de prélèvement (301b) et est aligné avec le premier chemin optique (302), le dispositif d'alignement (3041) est situé à une extrémité du second chemin optique (306) éloignée de la tête de liaison (301).

5. Système de liaison (300) selon l'une quelconque des revendications 1 à 4, dans lequel
l'ensemble de liaison comprend deux premiers chemins optiques (302), dans lesquels les premières extrémités (302a) de différents premiers chemins optiques (302) sont disposées dans des positions différentes, et les secondes extrémités (302b) de différents premiers chemins optiques (302) sont disposées dans des positions différentes sur la surface de prélèvement (301b) ;
le premier ensemble d'alignement (304) comprend un dispositif d'alignement (3041), et lorsque l'ensemble de liaison est situé à la première position, le dispositif d'alignement (3041) est aligné avec une seconde extrémité (302b) de l'un des premiers chemins optiques (302) ;
l'ensemble de liaison comprend en outre une unité d'entraînement configurée pour entraîner les deux premiers chemins optiques (302) à se déplacer par rapport au dispositif d'alignement (3041), de sorte que le dispositif d'alignement (3041) soit aligné avec une seconde extrémité (302b) de l'autre des premiers chemins optiques (302).

6. Système de liaison (300) de l'une quelconque des revendications 1 à 3, dans lequel
l'ensemble de liaison comprend deux premiers chemins optiques (302), dans lesquels les premières extrémités (302a) de différents premiers chemins optiques (302) sont disposées dans des positions différentes, et les secondes extrémités (302b) de différents premiers chemins optiques (302) sont disposées dans des positions différentes sur la surface de prélèvement (301b) ;
le premier ensemble d'alignement (304) comprend deux dispositifs d'alignement (3041) et deux seconds chemins optiques (306), dans lesquels différents dispositifs d'alignement (3041) sont situés aux extrémités de différents seconds chemins optiques (306) éloignés de la tête de liaison (301) ;
dans lequel différents seconds chemins optiques (306) sont alignés avec différents premiers chemins optiques (302), lorsque l'ensemble de liaison est situé dans la première position.

7. Système de liaison (300) selon la revendication 6, comprenant en outre :
une base (309) située sur la surface latérale (301c) de la tête de liaison (301) ;
un premier support (310-1) disposé parallèlement à la surface de prélèvement (301b) et configuré pour relier de manière fixe un premier des dispositifs d'alignement (3041) à la base ; et
un second support (310-2) disposé parallèlement à la surface de prélèvement (301b) et configuré pour relier de manière fixe un second des dispositifs d'alignement (3041) à la base.

8. Système de liaison (300) selon la revendication 6, comprenant en outre :
deux bases (309) disposées des deux côtés de la tête de liaison (301) respectivement ;
un premier support (310-1) disposé parallèlement à la surface de prélèvement (301b) et configuré pour relier de manière fixe un premier des dispositifs d'alignement (3041) à une première des bases (309) ; et
un second support (310-2) disposé parallèlement à la surface de prélèvement (301b) et configuré pour relier de manière fixe un second des dispositifs d'alignement (3041) à une seconde des bases (309).

9. Procédé de liaison, appliqué pour lier une première puce à lier à une seconde puce à lier sur une plaquette, comprenant :
la détermination (S100), par un premier ensemble d'alignement, d'une première valeur d'écart entre une position actuelle de la première puce à lier qui est prélevée et une première position cible ;
la détermination (S200), par un second ensemble d'alignement, d'une seconde valeur d'écart entre une position actuelle de la seconde puce à lier et une seconde position cible ;
le déplacement (S300), par un porte-plaquette, de la plaquette ou le déplacement, par un ensemble de liaison, de la première puce à lier selon la première valeur d'écart et la seconde valeur d'écart, pour aligner la première puce à lier avec la seconde puce à lier ; et
la liaison (S400), par l'ensemble de liaison, de la première puce à lier à la seconde puce à lier, après avoir aligné la première puce à lier avec la seconde puce à lier ;
dans lequel la détermination (S100), par le premier ensemble d'alignement, de la première valeur d'écart entre la position actuelle de la première puce à lier qui est prélevée et la première position cible comprend :
lorsque l'ensemble de liaison est situé dans une première position, la transmission, par un dispositif d'alignement dans le premier ensemble d'alignement, d'un signal optique de détection à une première extrémité d'un premier chemin optique via une seconde extrémité du premier chemin optique ;
la réflexion, par un premier réflecteur dans le premier chemin optique, du signal optique de détection ;
la réception, par le dispositif d'alignement, d'un signal optique de réflexion ;
la détermination, par le dispositif d'alignement, de la première valeur d'écart ;
dans lequel une tête de liaison configurée pour prélever la première puce à lier comprend une surface latérale perpendiculaire à une surface de prélèvement, et la seconde extrémité du premier chemin optique est disposée dans la surface latérale ;
dans lequel, lorsque l'ensemble de liaison est situé dans la première position, le dispositif d'alignement est situé à une extrémité d'un second chemin optique dans le premier ensemble d'alignement, éloignée de la surface latérale, et une autre extrémité du second chemin optique, proche de la surface latérale, est alignée avec la seconde extrémité du premier chemin optique.

10. Procédé de liaison selon la revendication 9, appliqué au système de liaison selon l'une quelconque des revendications 1 à 8, comprenant en outre :
la fourniture d'une puce d'étalonnage comprenant une première surface et une seconde surface disposées face à face, une première marque de positionnement située sur la première surface et une seconde marque de positionnement située sur la seconde surface, et des projections de la première marque de positionnement et de la seconde marque de positionnement sur la première surface coïncidant dans une direction perpendiculaire à la première surface ;
le prélèvement de la puce d'étalonnage, dans lequel une surface de prélèvement entre en contact avec la première surface de la puce d'étalonnage, et la première extrémité du premier chemin optique recouvre la première marque de positionnement ;
le maintien d'une position du premier ensemble d'alignement inchangée et le déplacement de la tête de liaison en prélevant la puce d'étalonnage, jusqu'à ce que la première marque de positionnement soit identifiée par le premier ensemble d'alignement, dans lequel une position de la puce d'étalonnage est déterminée comme la première position cible, lorsque la première marque de positionnement est identifiée par le premier ensemble d'alignement ;
le déplacement du second ensemble d'alignement lorsque la puce d'étalonnage est située dans la première position cible, jusqu'à ce que la seconde marque de positionnement soit identifiée par le second ensemble d'alignement, dans lequel le premier ensemble d'alignement et le second ensemble d'alignement sont déterminés comme étant situés dans des positions de référence, lorsque la seconde marque de positionnement est identifiée par le second ensemble d'alignement ; et
le maintien du premier ensemble d'alignement et du second ensemble d'alignement situés dans les positions de référence, et la réalisation d'opérations de détermination de la première valeur d'écart et de détermination de la seconde valeur d'écart.

11. Procédé de liaison selon la revendication 9, appliqué au système de liaison selon l'une quelconque des revendications 1 à 8, comprenant en outre :
la fourniture d'une puce d'étalonnage comprenant : une première surface et une seconde surface disposées face à face, une première marque de positionnement située sur la première surface et une seconde marque de positionnement située sur la seconde surface, et des projections de la première marque de positionnement et de la seconde marque de positionnement sur la première surface coïncidant dans une direction perpendiculaire à la première surface ;
le prélèvement de la puce d'étalonnage, dans lequel une surface de prélèvement entre en contact avec la première surface de la puce d'étalonnage, et la première extrémité du premier chemin optique recouvre la première marque de positionnement ;
le maintien d'une position du second ensemble d'alignement inchangée et le déplacement d'une surface de prélèvement en prélevant la puce d'étalonnage, jusqu'à ce que la seconde marque de positionnement soit identifiée par le second ensemble d'alignement, dans lequel la position de la puce d'étalonnage est déterminée comme la première position cible, lorsque la seconde marque de positionnement est identifiée par le second ensemble d'alignement ;
le déplacement du premier ensemble d'alignement lorsque la puce d'étalonnage est située dans la première position cible, jusqu'à ce que la première marque de positionnement soit identifiée par le premier ensemble d'alignement, dans lequel le premier ensemble d'alignement et le second ensemble d'alignement sont déterminés comme étant situés dans des positions de référence, lorsque la première marque de positionnement est identifiée par le premier ensemble d'alignement ; et
le maintien du premier ensemble d'alignement et du second ensemble d'alignement situés dans les positions de référence, et la réalisation d'opérations de détermination de la première valeur d'écart et de détermination de la seconde valeur d'écart.
